(19) Europäisches Patentamt
European Patent Office
Office européen des brevets

(11) EP 4 775 617 A1

(12) EUROPEAN PATENT APPLICATION
published in accordance with Art. 153(4) EPC

(43) Date of publication:
**15.07.2026 Bulletin 2026/29**

(21) Application number: **24862928.9**

(22) Date of filing: **06.09.2024**

(51) International Patent Classification (IPC):
***C08G 77/20** (2006.01)* ***C08F 299/08** (2006.01)*
***G02B 6/12** (2006.01)*

(52) Cooperative Patent Classification (CPC):
**C08F 299/08; C08G 77/20; G02B 6/12**

(86) International application number:
**PCT/JP2024/032123**

(87) International publication number:
**WO 2025/053279 (13.03.2025 Gazette 2025/11)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:
**07.09.2023 JP 2023145239**
**07.09.2023 JP 2023145240**
**29.03.2024 JP 2024058144**
**29.03.2024 JP 2024058145**

(71) Applicant: **Mitsubishi Chemical Corporation**
**Tokyo 100-8251 (JP)**

(72) Inventors:
- **KOSUGE, Takahiro**
  **Tokyo 100-8251 (JP)**
- **ANDO, Naoki**
  **Tokyo 100-8251 (JP)**
- **SAITO, Takahiro**
  **Tokyo 100-8251 (JP)**
- **FUJIMORI, Naomi**
  **Tokyo 100-8251 (JP)**

(74) Representative: **Hoffmann Eitle**
**Patent- und Rechtsanwälte PartmbB**
**Arabellastraße 30**
**81925 München (DE)**

# (54) ORGANOPOLYSILOXANE, ORGANOPOLYSILOXANE-CONTAINING RESIN COMPOSITION, CURED PRODUCT THEREOF, ORGANOPOLYSILOXANE FOR NEAR-INFRARED OPTICAL WAVEGUIDE, ORGANOPOLYSILOXANE-CONTAINING RESIN COMPOSITION FOR NEAR-INFRARED OPTICAL WAVEGUIDE, CURED PRODUCT FOR NEAR-INFRARED OPTICAL WAVEGUIDE, NEAR-INFRARED OPTICAL WAVEGUIDE, NEAR-INFRARED OPTICAL TRANSMISSION MEMBER, AND NEAR-INFRARED OPTICAL WAVEGUIDE PRODUCTION METHOD

(57) Provided is an organopolysiloxane for a near-infrared optical waveguide, the organopolysiloxane having an organic group containing a polymerizable alkenyl group and a siloxane unit (D unit) represented by $SiO_{2/2}$, wherein the proportion of an aromatic group is 20 mol% or less in a total of all groups bonded to silicon atoms; or a cured product including a crosslinked structure derived from an organic group containing a polymerizable alkenyl group and a siloxane unit (D unit) represented by $SiO_{2/2}$, the cured product having a refractive index of 1.400 or more and 1.500 or less at a wavelength of 1300 nm.

Fig 1

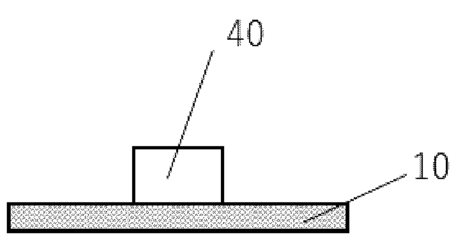


EP 4 775 617 A1

## Description

### Technical Field

The present invention relates to an organopolysiloxane, an organopolysiloxane composition and a cured product thereof, an organopolysiloxane for a near-infrared optical waveguide, a cured product for a near-infrared optical waveguide, a near-infrared optical waveguide, a near-infrared optical transmission member, and a method for producing a near-infrared optical waveguide.

### Background Art

In recent years, with increases in speed and capacity of information communication, an optical interconnect technology in which electrical wiring is replaced with optical wiring has attracted attention.

Electrical wiring for transmitting electrical signals has been used for transmission such as inter-device transmission, intra-device transmission, and inter-chip transmission. However, as the information capacity increases and the required transmission speed increases, the use of electrical wiring for transmitting electrical signals is close to its limit due to problems of wiring density and increased power consumption. An optical interconnect technology is being developed as a technology that replaces the electrical wiring.

In the optical interconnect technology, optical wiring is used for data transmission between devices and between circuits. The optical wiring has advantages such as low power consumption, high density wiring, and high speed communication. As an optical interconnect technology, with an increase in data communication capacity, an optical waveguide connecting a single-mode optical fiber and a silicon photonics circuit is being developed as a member for optical communication. Especially, an optical waveguide using a resist material and not requiring a reactive dry etching step has high productivity and has attracted attention.

In particular, in equipment of a data center in which high speed transmission is required, an optical waveguide connectable to a near-infrared single-mode quartz-based optical fiber is required. From the viewpoint of efficiently forming a fine optical waveguide, it is desired to form the optical waveguide by a cured product of a resin composition.

As in the case of an optical fiber, an optical waveguide connected to an optical fiber has a core at the center and a cladding covering the periphery of the core, and efficiently propagates light while totally reflecting the light. Therefore, there are required a higher refractive index of the core constituting the waveguide than that of the cladding and an appropriate difference in refractive index between the core and the cladding.

For example, Patent Literature 1 discloses an organopolysiloxane having an aromatic hydrocarbon group as a material for an optical transmission member.

### Citation List

#### Patent Literature

Patent Literature 1: JP 2005-163009 A

### Summary of Invention

#### Technical Problem

In the optical waveguide, it is also necessary to suppress a transmission loss indicating a degree of attenuation of an optical signal associated with a distance on a communication path when light is propagated. In addition, since the optical waveguide is connected to an optical fiber, it is important to suppress also an optical loss at the time of connection, i.e., a connection loss.

In Patent Literature 1 indicated above, the difference in refractive index between a core portion and a cladding portion can be adjusted by adjusting the molar proportion of the aromatic hydrocarbon group in the organopolysiloxane, but there is still room for improvement in transmission loss.

As for known optical waveguide materials, it has been exclusively reported to increase the difference in refractive index between the core portion and the cladding portion as in Patent Literature 1. However, no study has been conducted on the connection loss when the optical waveguide is connected to an optical fiber.

In view of the above problems, an object of the present invention is to provide an optical waveguide having properties generally required of an optical waveguide and having a significantly suppressed connection loss.

Solution to Problem

The present inventors have conducted intensive studies to solve the above problems. As a result, the present inventors have found that the connection loss is increased due to roughness of an end face of the optical waveguide, i.e., the state of the end face of the optical waveguide greatly contributes to the connection loss, and have also found that an organopolysiloxane having a specific structure and a cured product produced by curing a composition thereof can solve the above problems, thereby completing the present invention.
That is, the present invention provides the following.

(1) An organopolysiloxane represented by General Formula [1] described below:

$$(R^1R^2R^3SiO_{1/2})_{M1}(R^4R^5R^6SiO_{1/2})_{M2}$$

$$(R^7R^8SiO_{2/2})_{+}(R^9R^6SiO_{2/2})_{D2}$$

$$(R^{10}SiO_{3/2})_{T1}(R^6SiO_{3/2})_{T2}(SiO_{4/2})_{Q}$$

$$(O_{1/2}R^{11})_{Y1}(O_{1/2}R^6)_{Y2} \cdots \quad [1]$$

[in Formula [1], $R^1$ to $R^5$ and $R^7$ to $R^{11}$ are each independently one or two or more groups selected from an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or two or more organic groups containing a polymerizable alkenyl group, which are optionally the same or different;
$0 \leq M1$, $0 \leq Q$, $0 \leq Y1$, and $0 \leq Y2$;
$0 < D1 + D2$,

$$0 < M2 + D2 + T2,$$

and

$$M1 + M2 + D1 + D2 + T1 + T2 + Q = 1;$$

and
a proportion of an aromatic group in a total of all groups bonded to silicon atoms is 20 mol% or less].

(2) The organopolysiloxane according to item (1) above, wherein $0.1 < D1 + D2$ in Formula [1].
(3) The organopolysiloxane according to item (1) or (2) above, wherein $0 < D1$ in Formula [1].
(4) The organopolysiloxane according to any one of items (1) to (3) above, wherein $0.02 \leq Y1 \leq 0.25$ in Formula [1].
(5) The organopolysiloxane according to any one of items (1) to (4) above, wherein, in Formula [1], $R^7$ to $R^9$ do not contain an aromatic group.
(6) The organopolysiloxane according to any one of items (1) to (5) above, wherein, in Formula [1], $R^1$ to $R^{11}$ do not contain an aromatic group.
(7) The organopolysiloxane according to any one of items (1) to (6) above, wherein, in Formula [1], $R^6$ has one or more functional groups selected from the group represented by Formulae [2] to [5] described below in one molecule:

[Chem. 1]

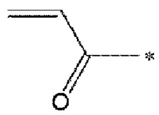 [2]

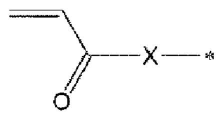 [3]

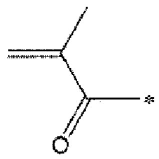 [4]

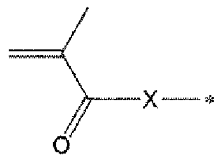 [5]

(in Formulae described above, X is a divalent organic group, and optionally contains a branched structure and/or a cyclic structure; when X is bonded to a silicon atom, an atom which is at a terminal of X and is directly bonded to silicon is a carbon atom; when X is bonded to an oxygen atom directly bonded to silicon, an atom which is at a terminal of X and is directly bonded to the oxygen atom is a carbon atom; and * represents a bond).

(8) The organopolysiloxane according to any one of items (1) to (7) above, wherein, in Formula [1], $R^6$ is an acryloyloxypropyl group and/or a methacryloyloxypropyl group.

(9) The organopolysiloxane according to any one of items (1) to (8) above, wherein, in General Formula [1], $R^7$ and $R^8$ are each independently an alkyl group having from 1 to 20 carbons.

(10) An organopolysiloxane-containing resin composition containing the organopolysiloxane described in any one of items (1) to (9) above and a polymerization initiator.

(11) A cured product produced by curing the organosiloxane-containing resin composition described in item (10) above.

(12) A near-infrared optical waveguide produced using the organosiloxane-containing resin composition described in item (10) above.

(13) A near-infrared optical waveguide including a core portion and a cladding portion, wherein both the core portion and the cladding portion are produced using the organosiloxane-containing resin composition described in item (10) above.

(14) A near-infrared optical transmission member including at least the near-infrared optical waveguide described in item (12) above.

(15) A near-infrared optical transmission member including at least the near-infrared optical waveguide described in item (13) above.

(16) A method for producing a near-infrared optical waveguide, the method including:

(i-1) applying a first curable polymer composition to a surface of a substrate to form a first polymer layer;
(i-2) irradiating at least one selected region of the first polymer layer with an active energy ray having a wavelength of from 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane-containing resin composition described in item (10) above.

(17) The method for producing a near-infrared optical waveguide according to item (16) above, further including:

(i-4) coating the surface of the substrate and the core with a second curable polymer composition to form a second polymer layer; and
(i-5) curing the second polymer layer to form an upper cladding.

(18) The method for producing a near-infrared optical waveguide according to item (17) above, wherein the second curable polymer composition is the organopolysiloxane-containing resin composition described in item (10) above.

(19) A method for producing a near-infrared optical waveguide, the method including:

(ii-1) applying a third curable polymer composition to a surface of a substrate to form a third polymer layer;
(ii-2) irradiating at least one selected region of the third polymer layer with an active energy ray having a wavelength of from 150 to 800 nm to produce a partially exposed layer having at least one exposed region and at least one unexposed region;
(ii-3) removing the unexposed region of the partially exposed layer with a solvent to form a patterned core;

(ii-4) coating the surface of the substrate and the core with a fourth curable polymer composition to form a fourth polymer layer; and
(ii-5) curing the fourth polymer layer to form an upper cladding, in this order, wherein

at least one of the third curable polymer composition or the fourth curable polymer composition is the organopolysiloxane-containing resin composition described in item (10) above.
(20) The method for producing a near-infrared optical waveguide according to item (19) above, wherein both the third curable polymer composition and the fourth curable polymer composition are the organopolysiloxane-containing resin composition described in item (10) above.
(21) A method for producing a near-infrared optical waveguide, the method including:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of from 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the organopolysiloxane-containing resin composition described in item (10) above.
(22) The method for producing a near-infrared optical waveguide according to item (21) above, wherein both the fifth curable polymer composition and the sixth curable polymer composition are the organopolysiloxane-containing resin composition described in item (10) above.
(23) A method for producing a near-infrared optical waveguide, the method including:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a wavelength of from 150 to 800 nm to produce a partially exposed layer having at least one exposed region and at least one unexposed region;
(iv-5) removing the unexposed region of the partially exposed layer with a solvent to form a patterned core;
(iv-6) coating the lower cladding and the core with a seventh curable polymer composition to form a seventh polymer layer; and
(iv-7) curing the seventh polymer layer to form an upper cladding, in this order, wherein

at least one of the fifth curable polymer composition, the sixth curable polymer composition, or the seventh curable polymer composition is the organopolysiloxane-containing resin composition described in item (10) above.
(24) The method for producing a near-infrared optical waveguide according to item (23) above, wherein all the fifth curable polymer composition, the sixth curable polymer composition, and the seventh curable polymer composition are the organopolysiloxane-containing resin composition described in item (10) above.
(25) A cured product including a crosslinked structure derived from an organic group containing a polymerizable alkenyl group; and a siloxane unit (D unit) represented by $SiO_{2/2}$, wherein the cured product has a refractive index of 1.400 or more and 1.500 or less at a wavelength of 1300 nm.
(26) The cured product according to item (25) above, wherein the cured product has a refractive index of 1.400 or more and 1.500 or less at a wavelength of 589 nm.
(27) The cured product according to item (25) or (26) above, wherein the cured product is produced by curing an organopolysiloxane represented by General Formula [1] described below:

$$(R^1R^2R^3SiO_{1/2})_{M1}(R^4R^5R^6SiO_{1/2})_{M2}$$

$$(R^7R^8SiO_{2/2})_{D1}\ (R^9R^6SiO_{2/2})_{D2}$$

$$(R^{10}SiO_{3/2})_{T1}(R^6SiO_{3/2})_{T2}(SiO_{4/2})_{Q}$$

$$(O_{1/2}R^{11})_{Y1}(O_{1/2}R^6)_{Y2} \cdots \quad [1]$$

[in Formula [1], $R^1$ to $R^5$ and $R^7$ to $R^{11}$ are each independently one or two or more groups selected from an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or two or more organic groups containing a polymerizable alkenyl group, which are optionally the same or different;
$0 \leq M1$, $0 \leq Q$, $0 \leq Y1$, and $0 \leq Y2$;

$$0 < D1 + D2,$$

$$0 < M2 + D2 + T2,$$

and

$$M1 + M2 + D1 + D2 + T1 + T2 + Q = 1;$$

and
a proportion of an aromatic group in a total of all groups bonded to silicon atoms is 20 mol% or less].

(28) The cured product according to item (27) above, wherein $0.1 < D1 + D2$ in Formula [1].
(29) The cured product according to item (27) or (28) above, wherein $0 < D1$ in Formula [1].
(30) The cured product according to any one of items (27) to (29) above, wherein $0.02 \leq Y1 \leq 0.25$ in Formula [1].
(31) The cured product according to any one of items (27) to (30) above, wherein, in Formula [1], $R^1$ to $R^{11}$ do not contain an aromatic group.
(32) The cured product according to any one of items (27) to (31) above, wherein, in Formula [1], $R^6$ has one or more functional groups selected from the group represented by Formulae [2] to [5] described below in one molecule:

[Chem. 2]

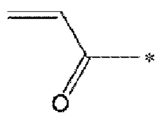
[2]

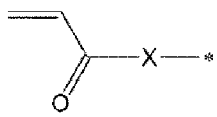
[3]

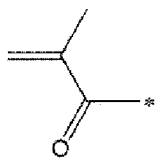
[4]

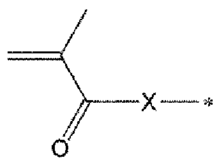
[5]

(in Formulae described above, X is a divalent organic group, and optionally contains a branched structure and/or a cyclic structure; when X is bonded to a silicon atom, an atom which is at a terminal of X and is directly bonded to silicon is a carbon atom; when X is bonded to an oxygen atom directly bonded to silicon, an atom which is at a terminal of X and is directly bonded to the oxygen atom is a carbon atom; and * represents a bond).
(33) The cured product according to any one of items (27) to (32) above, wherein, in Formula [1], $R^6$ is an acryloyloxypropyl group and/or a methacryloyloxypropyl group.
(34) The cured product according to any one of items (27) to (33) above, wherein, in General Formula [1], $R^7$ and $R^8$ are each independently an alkyl group having from 1 to 20 carbons.
(35) A near-infrared optical waveguide containing the cured product described in any one of items (25) to (34) above.
(36) A near-infrared waveguide including a core portion and a cladding portion, wherein both the core portion and the cladding portion contain the cured product described in any one of items (25) to (34) above.
(37) A near-infrared optical transmission member including at least the near-infrared optical waveguide described in item (35) above.
(38) A near-infrared optical transmission member including at least the near-infrared optical waveguide described in item (36) above.
(39) An organopolysiloxane for a near-infrared optical waveguide, the organopolysiloxane containing:

an organic group containing a polymerizable alkenyl group; and
a siloxane unit (D unit) represented by $SiO_{2/2}$, wherein
a proportion of an aromatic group is 20 mol% or less in a total of all groups bonded to silicon atoms.

(40) The organopolysiloxane for a near-infrared optical waveguide according to item (39) above, wherein the organopolysiloxane is represented by General Formula [1] described below:

$$(R^1R^2R^3SiO_{1/2})_{M1}(R^4R^5R^6SiO_{1/2})_{M2}$$

$$(R^7R^8SiO_{2/2})_{D1}(R^9R^6SiO_{2/2})_{D2}$$

$$(R^{10}SiO_{3/2})_{T1}(R^6SiO_{3/2})_{T2}(SiO_{4/2})_Q$$

$$(O_{1/2}R^{11})_{Y1}(O_{1/2}R^6)_{Y2} \cdots \quad [1]$$

[in Formula [1], $R^1$ to $R^5$ and $R^7$ to $R^{11}$ are each independently one or more groups selected from the group consisting of an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or more organic groups containing a polymerizable alkenyl group, and when a plurality of $R^6$s are present, they are optionally the same or different;
a proportion of an aromatic group in a total of $R^1$ to $R^{11}$ is 20 mol% or less;
$0 \leq M1$, $0 \leq Q$, $0 \leq Y1$, and $0 \leq Y2$;

$$0 < D1 + D2;$$

$$0 < M2 + D2 + T2;$$

and

$$M1 + M2 + D1 + D2 + T1 + T2 + Q = 1].$$

(41) The organopolysiloxane for a near-infrared optical waveguide according to item (40) above, wherein $0.1 < D1 + D2$ in Formula [1].
(42) The organopolysiloxane for a near-infrared optical waveguide according to item (40) or (41) above, wherein $0 < D1$ in Formula [1].
(43) The organopolysiloxane for a near-infrared optical waveguide according to any one of items (40) to (42) above, wherein $0.02 \leq Y1 \leq 0.25$ in Formula [1].
(44) The organopolysiloxane for a near-infrared optical waveguide according to any one of items (40) to (43) above, wherein, in Formula [1], $R^7$ to $R^9$ do not contain an aromatic group.
(45) The organopolysiloxane for a near-infrared optical waveguide according to any one of items (40) to (44) above, wherein, in Formula [1], $R^6$ has one or more functional groups selected from the group represented by Formulae [2] to [5] described below in one molecule:

[Chem. 3]

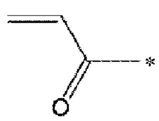 [2] 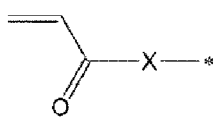 [3]

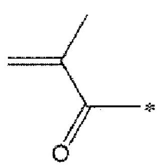 [4] 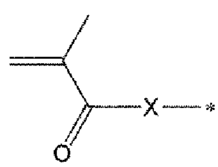 [5]

(in Formulae described above, X is a divalent organic group, and optionally contains a branched structure and/or a

cyclic structure; when X is bonded to a silicon atom, an atom which is at a terminal of X and is directly bonded to silicon is a carbon atom; when X is bonded to an oxygen atom directly bonded to silicon, an atom which is at a terminal of X and is directly bonded to the oxygen atom is a carbon atom; and * represents a bond).
(46) The organopolysiloxane for a near-infrared optical waveguide according to any one of items (40) to (45) above, wherein, in Formula [1], $R^6$ is an acryloyloxypropyl group and/or a methacryloyloxypropyl group.
(47) The organopolysiloxane for a near-infrared optical waveguide according to any one of items (40) to (46) above, wherein, in Formula [1], $R^1$ to $R^{11}$ do not contain an aromatic group.
(48) An organopolysiloxane-containing resin composition for a near-infrared optical waveguide, the resin composition containing the organopolysiloxane for a near-infrared optical waveguide described in any one of items (39) to (47) above and a polymerization initiator.
(49) A cured product for a near-infrared optical waveguide, the cured product being produced by curing the organopolysiloxane-containing resin composition for a near-infrared optical waveguide described in item (48) above.
(50) A near-infrared optical waveguide produced using the organopolysiloxane-containing resin composition for a near-infrared optical waveguide described in item (48) above.
(51) A near-infrared waveguide including a core portion and a cladding portion, wherein both the core portion and the cladding portion are produced using the organopolysiloxane-containing resin composition for a near-infrared optical waveguide described in item (48) above.
(52) A near-infrared optical transmission member including at least the near-infrared optical waveguide described in item (50) above.
(53) A near-infrared optical transmission member including at least the near-infrared optical waveguide described in item (51) above.
(54) A method for producing a near-infrared optical waveguide, the method including:

(i-1) applying a first curable polymer composition to a surface of a substrate to form a first polymer layer;
(i-2) irradiating at least one selected region of the first polymer layer with an active energy ray having a wavelength of from 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane-containing resin composition for a near-infrared optical waveguide described in item (48) above.
(55) The method for producing a near-infrared optical waveguide according to item (54) above, further including:

(i-4) coating the surface of the substrate and the core with a second curable polymer composition to form a second polymer layer; and
(i-5) curing the second polymer layer to form an upper cladding.

(56) The method for producing a near-infrared optical waveguide according to item (55) above, wherein the second curable polymer composition is the organopolysiloxane-containing resin composition for a near-infrared optical waveguide described in item (48) above.
(57) A method for producing a near-infrared optical waveguide, the method including:

(ii-1) applying a third curable polymer composition to a surface of a substrate to form a third polymer layer;
(ii-2) irradiating at least one selected region of the third polymer layer with an active energy ray having a wavelength of from 150 to 800 nm to produce a partially exposed layer having at least one exposed region and at least one unexposed region;
(ii-3) removing the unexposed region of the partially exposed layer with a solvent to form a patterned core;
(ii-4) coating the surface of the substrate and the core with a fourth curable polymer composition to form a fourth polymer layer; and
(ii-5) curing the fourth polymer layer to form an upper cladding, in this order, wherein at least one of the third curable polymer composition or the fourth curable polymer composition is the organopolysiloxane-containing resin composition for a near-infrared optical waveguide described in item (48) above.

(58) The method for producing a near-infrared optical waveguide according to item (57) above, wherein both the third curable polymer composition and the fourth curable polymer composition are the organopolysiloxane-containing resin composition for a near-infrared optical waveguide described in item (48) above.
(59) A method for producing a near-infrared optical waveguide, the method including:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of from 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the organopolysiloxane-containing resin composition for a near-infrared optical waveguide described in item (48) above.
(60) The method for producing a near-infrared optical waveguide according to item (59), wherein both the fifth curable polymer composition and the sixth curable polymer composition are the organopolysiloxane-containing resin composition for a near-infrared optical waveguide described in item (48) above.
(61) A method for producing a near-infrared optical waveguide, the method including:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a wavelength of from 150 to 800 nm to produce a partially exposed layer having at least one exposed region and at least one unexposed region;
(iv-5) removing the unexposed region of the partially exposed layer with a solvent to form a patterned core;
(iv-6) coating the lower cladding and the core with a seventh curable polymer composition to form a seventh polymer layer; and
(iv-7) curing the seventh polymer layer to form an upper cladding, in this order, wherein

at least one of the fifth curable polymer composition, the sixth curable polymer composition, or the seventh curable polymer composition is the organopolysiloxane-containing resin composition for a near-infrared optical waveguide described in item (48) above.
(62) The method for producing a near-infrared optical waveguide according to item (61), wherein all the fifth curable polymer composition, the sixth curable polymer composition, and the seventh curable polymer composition are the organopolysiloxane-containing resin composition for a near-infrared optical waveguide described in item (48) above.

## Advantageous Effects of Invention

According to the present invention, it is possible to provide an optical waveguide having properties generally required of an optical waveguide and having a significantly suppressed connection loss. More specifically, it is possible to provide an optical waveguide in which the connection loss is significantly suppressed, the transmission loss is low, and the difference in refractive index between the core portion and the cladding portion is controlled. The optical waveguide formed of the organopolysiloxane of the present invention and the cured product produced by curing the composition thereof are particularly useful as a near-infrared optical waveguide and a near-infrared optical transmission member.

## Brief Description of Drawings

FIG. 1 is a schematic sectional view of an optical waveguide having a core formed on a substrate.
FIG. 2 is a schematic sectional view of an optical waveguide having a core and an upper cladding formed on a substrate.
FIG. 3 is a schematic sectional view of an optical waveguide having a lower cladding and a core formed on a substrate.
FIG. 4 is a schematic sectional view of an optical waveguide having a lower cladding, a core, and an upper cladding formed on a substrate.

## Description of Embodiments

Embodiments of the present invention (hereinafter may be referred to as the present embodiment) will be described in detail below; however, the present invention is not limited to the following description, which is an example of

the embodiments.

Organopolysiloxane

An organopolysiloxane of a first embodiment of the present invention (hereinafter may be referred to as the present first embodiment) has an organic group containing a polymerizable alkenyl group and a siloxane unit (D unit) represented by $SiO_{2/2}$. In the organopolysiloxane of the present embodiment, the proportion of an aromatic group in a total of all groups bonded to silicon atoms is 20 mol% or less.

For applications of an optical waveguide having a large difference in refractive index between a core portion and a cladding portion for a multimode, an organopolysiloxane having an aromatic group has been reported. However, the present inventors have found that a near-infrared optical waveguide produced using an organopolysiloxane in which the proportion of the aromatic group in the total of all the groups bonded to the silicon atoms is 20 mol% or less has a small connection loss.

Without being bound by any particular theory, the following is considered as to the influence of the aromatic group.

That is, it is considered that, when the proportion of the aromatic group contained in the organopolysiloxane is 20 mol% or less, the interaction between aromatic rings is weakened, the cured product produced by curing the organopolysiloxane-containing resin composition is less likely to be brittle, and cracks are less likely to occur, and thus that an end face when the waveguide is cut is less likely to be roughened. It is considered that suppression of the roughness of the end face of the waveguide suppresses light scattering and reduces the connection loss.

In the organopolysiloxane of the present embodiment, the proportion of the aromatic group in the total of all the groups bonded to the silicon atoms is 20 mol% or less, and therefore, the roughness of the end face of the optical waveguide produced using the organopolysiloxane can be suppressed, and the connection loss can be suppressed. In the present embodiment, the proportion of the aromatic group in all the groups bonded to the silicon atoms in the organopolysiloxane is preferably 15 mol% or less, more preferably 10 mol% or less, still more preferably 5 mol% or less, and yet still more preferably 1 mol% or less.

As described above, the organopolysiloxane of the present embodiment may take both an aspect having an aromatic group and an aspect not having an aromatic group at all. When the organopolysiloxane has an aromatic group, the lower limit thereof is not limited as long as the effects of the present invention are not impaired, and may be, for example, 0.01 mol% or 0.1 mol%. According to one aspect of the present invention, it is also preferable that the organopolysiloxane should not have an aromatic group bonded to a silicon atom at all.

The content of the aromatic group can be confirmed by $^{1}$H-NMR or $^{29}$Si-NMR. The expression "not have an aromatic group at all" means that, in an NMR chart, an aromatic group can be identified, but there is no clear peak that can be confirmed.

In the present specification, the "transmission loss" and the "connection loss" of the optical waveguide are defined as follows.

An optical fiber is brought close to an end face of a linear optical waveguide to make light incident, and the intensity of the light emitted from the other end face of the waveguide is measured to determine the optical loss. An optical loss value (dB) is calculated using Formula [6] described below.

[Math. 1]

$$-10\log_{10}\left(\frac{P_2}{P_1}\right) \quad \cdots \text{Formula [6]}$$

[In Formula [6], $P_1$ represents incident light intensity, and $P_2$ represents emitted light intensity.]

Subsequently, when linear approximation is performed from a graph in which the horizontal axis represents waveguide length (cm) and the vertical axis represents attenuation (dB), the slope is defined as the transmission loss (dB/cm) and the intercept is defined as the connection loss (dB).

The connection loss obtained as an intercept from the linear approximation represents an optical loss that occurs when light enters the optical waveguide from the optical fiber. The present inventors have found that the physical shape (roughness) of the end face of the optical waveguide has a large influence on the connection loss.

In the present embodiment, the organopolysiloxane contains a polymerizable alkenyl group in the structure, and thus a cured product can be easily produced by a polymerization initiator. That is, it is suitable for formation of a core by photolithography.

In the organopolysiloxane of the present embodiment, the density of the cured product to be produced can be controlled by adjusting the content of the polymerizable alkenyl group, and the refractive index of the cured product at a near-infrared wavelength can be controlled to from 1.400 to 1.500.

Furthermore, when the organopolysiloxane has a siloxane unit (D unit) represented by $SiO_{2/2}$, the cured product has reflow resistance while maintaining the refractive index at a near-infrared wavelength of from 1.400 to 1.500, and toughness is imparted while suppressing the optical loss, particularly the transmission loss, to a low level, whereby the roughness of the end face when the waveguide is cut can be suppressed, and the loss of the connection loss can be significantly suppressed.

Organopolysiloxane

In the present first embodiment, the organopolysiloxane is characterized by having a structure represented by Formula [1] described below:

$$(R^1R^2R^3SiO_{1/2})_{M1}(R^4R^5R^6SiO_{1/2})_{M2}$$

$$(R^7R^8SiO_{2/2})_{D1}(R^9R^6SiO_{2/2})_{D2}$$

$$(R^{10}SiO_{3/2})_{T1}(R^6SiO_{3/2})_{T2}(SiO_{4/2})_Q$$

$$(O_{1/2}R^{11})_{Y1}(O_{1/2}R^6)_{Y2} \cdots \quad [1]$$

[in Formula [1], $R^1$ to $R^5$ and $R^7$ to $R^{11}$ are each independently one or more groups selected from the group consisting of an organic group, a reactive functional group, and a hydrogen atom;
$R^1$ to $R^3$, $R^7$, $R^8$, $R^{10}$, and $R^{11}$ do not contain a polymerizable alkenyl group; $R^6$ is one or more organic groups containing a polymerizable alkenyl group, and when a plurality of $R^6$s are present, they are optionally the same or different;
a proportion of aromatic groups in a total of $R^1$ to $R^{11}$ is 20 mol% or less;
$0 \leq M1$, $0 \leq Q$, $0 \leq Y1$, and $0 \leq Y2$;

$$0 < D1 + D2, \text{ and } 0 < M2 + D2 + T2;$$

and

$$M1 + M2 + D1 + D2 + T1 + T2 + Q = 1].$$

In General Formula [1], M1 and M2 represent proportions (on a molar basis) of so-called M units ($SiO_{1/2}$) (hereinafter may be referred to simply as "M units") having one oxygen atom bonded to a silicon atom, when M1 + M2 + D1 + D2 + T1 + T2 + Q = 1. Similarly, D1 and D2 represent proportions (on a molar basis) of D units ($SiO_{2/2}$) having two oxygen atoms bonded to silicon atoms (hereinafter may be referred to simply as "D units"), T1 and T2 represent proportions (on a molar basis) of T units ($SiO_{3/2}$) having three oxygen atoms bonded to silicon atoms (hereinafter may be referred to simply as "T units"), and Q represents a proportion (on a molar basis) of a Q unit ($SiO_{4/2}$) having four oxygen atoms bonded to silicon atoms (hereinafter may be referred to simply as "Q unit"). As described above, in the present first embodiment, the organopolysiloxane represented by General Formula [1] has a proportion of the aromatic group of 20 mol% or less in the total of all the groups bonded to the silicon atoms.
M2, D2, and T2 represent proportions of the M unit, the D unit, and the T unit, respectively, in which $R^6$, i.e., an organic group containing a polymerizable alkenyl group is bonded to a silicon atom.
Y1 represents a relative proportion of a structure having no polymerizable alkenyl group and having a group selected from the group consisting of an organic group, a reactive functional group, and a hydrogen atom ($O_{1/2}R^{11}$), specifically, a structure having an alkoxy group or a silanol group, when M1 + M2 + D1 + D2 + T1 + T2 + Q = 1, and Y2 represents a relative proportion of a structure having an organic group containing a polymerizable alkenyl group ($O_{1/2}R^6$).
$0 \leq M1$, $0 \leq Q$, $0 \leq Y1$, and $0 \leq Y2$ mean that M1, Q, Y1 and Y2 are each 0 or more, and may be 0, i.e., these structural units may not be present.
$0 < D1 + D2$ means that the organopolysiloxane has a D unit, and $0 < M2 + D2 + T2$ means that the organopolysiloxane has at least one of an M unit, a D unit, or a T unit having an organic group containing a polymerizable alkenyl group.
In the present embodiment, the organopolysiloxane preferably has a branched structure. This means that at least either one of a T unit and a Q unit is present.

$$\text{Coefficient } M2 + D2 + T2$$

As described above, in the organopolysiloxane of the present embodiment, $0 < M2 + D2 + T2$. That is, the organopolysiloxane of the present embodiment contains a polymerizable alkenyl group, and a cured product can be easily produced using a composition containing a polymerization initiator described below. The value of M2 + D2 + T2 is preferably $0.10 \leq M2 + D2 + T2$, more preferably $0.12 \leq M2 + D2 + T2$, still more preferably $0.15 \leq M2 + D2 + T2$, and yet still more preferably $0.20 \leq M2 + D2 + T2$. When the value is within this range, the organopolysiloxane is sufficiently cured during the production of a cured product, and compatibility with other components added to the organopolysiloxane-containing resin composition described below is good.

The upper limit of M2 + D2 + T2 is not particularly limited, but is preferably $M2 + D2 + T2 \leq 0.75$, more preferably $M2 + D2 + T2 \leq 0.60$, and still more preferably $M2 + D2 + T2 \leq 0.55$. When the value is within the above range, the amount of the polymerizable alkenyl group contained in the organopolysiloxane is appropriate, and a cured product having a crosslinking density to such an extent that the cured product does not become brittle is produced.

As described above, $0.10 \leq M2 + D2 + T2 \leq 0.75$ is preferable, $0.12 \leq M2 + D2 + T2 \leq 0.60$ is more preferable, and $0.15 \leq M2 + D2 + T2 \leq 0.55$ is still more preferable.

$O_{1/2}R^{11}$

($O_{1/2}R^{11}$) is a structure having no polymerizable alkenyl group and having a group selected from the group consisting of an organic group, a reactive functional group, and a hydrogen atom, and specifically, is an alkoxy group and/or a silanol group bonded to silicon. The viscosity of the organopolysiloxane can be controlled by the structural unit, and can be adjusted to a viscosity suitable for molding. The silanol group has an effect of increasing the viscosity, and the alkoxy group has an effect of decreasing the viscosity.

When the content proportion of the alkoxy group or the silanol group is low, the amount of the terminal group having high mobility is small, and the siloxane skeleton becomes a rigid cage type, so that the viscosity increases. Meanwhile, when the content proportion of the alkoxy group or the silanol group is high, the amount of the terminal group having high mobility is large, and the siloxane skeleton also has a flexible random structure or ladder structure which is not a cage type, so that the viscosity decreases.

Coefficient Y1

Y1 indicating the content proportion of ($O_{1/2}R^{11}$) is 0 or a positive value. Y1 indicates the total content proportion of the silanol group and the alkoxy group in the organopolysiloxane, from the definition of $R^{11}$. The range of the coefficient Y1 is usually 0 or more, preferably 0.02 or more, more preferably 0.025 or more, still more preferably 0.03 or more, and yet still more preferably 0.035 or more, from the viewpoint of synthesis of the organopolysiloxane described below, adjustment of the viscosity required for the production of the organopolysiloxane-containing resin composition, and toughness of the cured product.

Meanwhile, from the viewpoint of storage stability and handleability, the upper limit of the coefficient Y1 is usually 0.30 or less, preferably 0.25 or less, more preferably less than 0.25, still more preferably 0.2 or less, yet still more preferably 0.20 or less, especially preferably 0.15 or less, and particularly preferably 0.10 or less.

As a preferred range, in Formula [1], $0.02 \leq Y1 \leq 0.30$ is preferred, $0.02 \leq Y1 \leq 0.25$ is more preferred, $0.025 \leq Y1 < 0.25$ is still more preferred, and $0.03 \leq Y1 \leq 0.20$ is yet still more preferred.

Y1 represents a value relative to $M1 + M2 + D1 + D2 + T1 + T2 + Q = 1$.

Coefficient Y2

Y2 is the content proportion of the organic group containing a polymerizable alkenyl group bonded to silicone via an oxygen atom ($O_{1/2}R^6$) in the organopolysiloxane. Y2 is 0 or a positive value. Preferably, $Y2 > 0.25$, more preferably $Y2 > 0.30$, and still more preferably $Y2 > 0.35$. When $Y2 > 0.25$, the compatibility with other resins is improved. The organic group containing a polymerizable alkenyl group is hydrolyzed with water and easily eliminated, and therefore a water absorption rate may increase. Therefore, it is preferable to use the organic group in a method that is not easily affected by water.

Meanwhile, in environments affected by water, when Y2 is large, the cured product is likely to be brittle due to water, and therefore $Y2 < 0.4$ is preferable, $Y2 < 0.3$ is more preferable, and $Y2 < 0.2$ is still more preferable. Also, Y2 is preferably 0.

Y2 represents a value relative to $M1 + M2 + D1 + D2 + T1 + T2 + Q = 1$.

Coefficient M1

The M unit not having $R^6$ having a polymerizable alkenyl group is not an essential constituent element in the organopolysiloxane of the present embodiment, but may be contained therein. That is, $M1 > 0$ may be satisfied, and the

organopolysiloxane can be improved in storage stability and reduced in viscosity by substituting any of the alkoxy group and the silanol group of the organopolysiloxane with the M unit. When the amount of the M unit is too large, the amount of the polymerizable alkenyl group contained in one molecule of the organopolysiloxane is small, and curing failure is likely to occur, and therefore, usually $M1 \leq 0.6$, preferably $M1 \leq 0.55$, more preferably $M1 \leq 0.5$, and still more preferably $M1 \leq 0.4$.

Coefficient D1 + D2

As described above, in the organopolysiloxane of the present embodiment, $0 < D1 + D2$. That is, since the organopolysiloxane of the present embodiment has a D unit and a flexible moiety is introduced, a cured product produced from the organopolysiloxane of the present embodiment is less likely to crack at the time of cutting. In particular, the near-infrared optical waveguide produced using the organopolysiloxane of the present embodiment has less roughness of the end face generated at the time of cutting, and the connection loss is low.

The value of D1 + D2 is preferably $0.1 < D1 + D2$, more preferably $0.20 \leq D1 + D2$, still more preferably $0.25 \leq D1 + D2$, and yet still more preferably $0.30 \leq D1 + D2$. When the value is within the above range, the cured film to be produced has more excellent toughness, and is less likely to crack at the time of cutting.

The upper limit of the value of D1 + D2 is not particularly limited, but is preferably $D1 + D2 \leq 0.80$, more preferably $D1 + D2 \leq 0.75$, and still more preferably $D1 + D2 \leq 0.70$. When the value is within the above range, the content proportion of a flexible component contained in the organopolysiloxane is appropriate, and a cured product maintaining heat resistance can be produced.

As described above, the value of D1 + D2 is preferably $0.1 < D1 + D2 \leq 0.80$, more preferably $0.20 \leq D1 + D2 \leq 0.80$, still more preferably $0.25 \leq D1 + D2 \leq 0.75$, and yet still more preferably $0.30 \leq D1 + D2 \leq 0.70$.

Since the D unit structure which does not have a polymerizable alkenyl group and does not serve as a crosslinking point has a higher effect of imparting toughness, D2 may be 0 within the range of the value of D1 + D2. From the same viewpoint, D1 is preferably $0 < D1$, more preferably $0.1 < D1$, still more preferably $0.20 \leq D1$, yet still more preferably $0.25 \leq D1$, and particularly preferably $0.30 \leq D1$. The upper limit of D1 is not particularly limited, but is preferably $D1 \leq 0.80$, more preferably $D1 \leq 0.75$, and still more preferably $D1 \leq 0.70$.

Coefficient T1

In the organopolysiloxane of the present embodiment, the T unit having no polymerizable alkenyl group is not an essential constituent element, but the organopolysiloxane contains such a unit, so that the compatibility with other components added to the organopolysiloxane-containing resin composition described below can be improved. That is, T1 may be 0, and when $T1 > 0$, preferably $T1 \geq 0.01$, more preferably $T1 \geq 0.05$, and still more preferably $T1 \geq 0.1$.

Meanwhile, when the content proportion of the T unit having no polymerizable alkenyl group is too high, curing failure is likely to occur due to steric hindrance of the organic group to be introduced. Therefore, the content proportion T1 of the T unit having no polymerizable alkenyl group is preferably $T1 \leq 0.5$, more preferably $T1 \leq 0.4$, and still more preferably $T1 \leq 0.3$.

Coefficient Q

In the organopolysiloxane of the present embodiment, the Q unit is not an essential constituent element, but silicon is in the most oxidized form, and the Q unit is contained in the structure of the organopolysiloxane, so that the heat resistance of the cured product can be increased. The Q unit is also contained in quartz, and it is also possible to produce a cured product having a refractive index close to that of the core material of the near-infrared single-mode quartz-based optical fiber by using an organopolysiloxane-containing resin composition having the Q unit described below. Q indicating the content proportion of the Q unit may be 0 or 0 or more, i.e., $Q \geq 0$. The coefficient Q is preferably $Q \geq 0.04$, more preferably $Q \geq 0.10$, still more preferably $Q \geq 0.15$, and yet still more preferably $Q \geq 0.20$.

Meanwhile, when the amount of the Q unit is too large, the composition tends to be solid or have a high viscosity, and the handleability tends to be lowered. Thus, usually $Q \leq 0.65$, preferably $Q \leq 0.6$, more preferably $Q \leq 0.45$, and still more preferably $Q \leq 0.40$.

From the above, the coefficients in Formula [1] are preferably $0.10 \leq M2 + D2 + T2 \leq 0.75$, $0.02 \leq Y1 \leq 0.25$, $Y2 < 0.4$, $M1 \leq 0.6$, $0.1 < D1 + D2 \leq 0.80$, $T1 \leq 0.5$, and $Q \leq 0.65$, more preferably $0.10 \leq M2 + D2 + T2 \leq 0.75$, $0.02 \leq Y1 \leq 0.25$, $Y2 < 0.4$, $M1 \leq 0.6$, $0.20 \leq D1 + D2 \leq 0.80$, $T1 \leq 0.5$, and $Q \leq 0.65$, still more preferably $0.12 \leq M2 + D2 + T2 \leq 0.60$, $0.025 \leq Y1 \leq 0.25$, $Y2 < 0.3$, $M1 \leq 0.55$, $0.25 \leq D1 + D2 \leq 0.75$, $T1 \leq 0.4$, and $Q \leq 0.6$, and yet still more preferably $0.15 \leq M2 + D2 + T2 \leq 0.55$, $0.03 \leq Y1 \leq 0.20$, $Y2 < 0.2$, $M1 \leq 0.4$, $0.30 \leq D1 + D2 \leq 0.70$, $T1 \leq 0.3$, and $Q \leq 0.45$.

$R^6$

In the present embodiment, $R^6$ is an organic group containing a polymerizable alkenyl group. Specific examples thereof include groups having an acryloyl group, a methacryloyl group, a vinyl group, a styryl group, or the like. In the organopolysiloxane of the present embodiment, the proportion of the aromatic group in all the groups bonded to the silicon atoms is required to be 20 mol% or less, and therefore $R^6$ is preferably a group having a polymerizable alkenyl group and having no aromatic group. $R^6$ more preferably has at least one or more functional groups selected from the group represented by Formulae [2] to [5] described below in one molecule.

[Chem. 4]

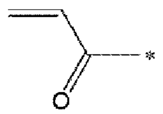 [2] 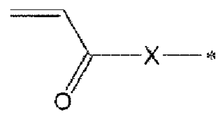 [3]

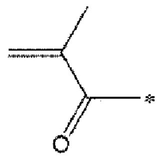 [4] 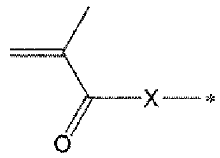 [5]

(In Formulae described above, * represents a bond.)
More preferably, $R^6$ has at least one or more functional groups selected from the group consisting of an acryloyloxypropyl group, an acryloyloxyoctyl group, a methacryloyloxypropyl group, and a methacryloyloxyoctyl group in one molecule, and among these, particularly preferably has an acryloyloxypropyl group and/or a methacryloyloxypropyl group in one molecule.
In Formulae [3] and [5], X is a divalent organic group, and may include a branched structure and/or a cyclic structure. X may contain at least one selected from the group consisting of oxygen, nitrogen, phosphorus, sulfur, and halogen, in addition to carbon and hydrogen. When X and a silicon atom are bonded, the atom which is at a terminal of X and is directly bonded to silicon is a carbon atom. When X is bonded to an oxygen atom directly bonded to silicon, the atom which is at a terminal of X and is directly bonded to the oxygen atom is a carbon atom. For example, a divalent branched structure having from 1 to 20 carbons, a hydrocarbon group which may contain a non-aromatic cyclic structure, a group derived from polyalkylene glycol, or the like is suitably used as the group represented by X.
In the present invention, the respective units constituting the M unit, the D unit, and the T unit are not necessarily all the same. For example, the unit ($R^1R^2R^3SiO_{1/2}$) which is the coefficient M1 may have different structures, for example, in which a certain $R^1$ group is a hydrogen atom and a certain $R^1$ group is a methyl group. This is also common to other $R^2$ to $R^{10}$ and X, and is also common to $R^{11}$ and $R^6$ in the units ($O_{1/2}R^{11}$) and ($O_{1/2}R^6$).

$R^1$ to $R^5$and $R^7$ to $R^{11}$

$R^1$ to $R^5$ and $R^7$ to $R^{11}$ are each independently one or more groups selected from the group consisting of an organic group, a reactive functional group, and a hydrogen atom.
When $R^1$ to $R^5$ and $R^7$ to $R^{11}$ are organic groups, they are preferably organic groups having from 1 to 20 carbons. Specifically, the organic group is preferably an alkyl group such as a methyl group, an ethyl group, a propyl group, an isopropyl group, an n-butyl group, a sec-butyl group, a tert-butyl group, an octyl group, or a cyclohexyl group, a furanyl group, or a polyether group such as a polyalkylene glycol group, and more preferably a methyl group.
For example, $R^7$ and $R^8$ in the coefficient D1 portion are each independently preferably an alkyl group having from 1 to 20 carbons. When $R^7$ and $R^8$ in the coefficient D1 portion are alkyl groups having from 1 to 20 carbons, the D unit is non-aromatic and steric hindrance is reduced, and thus the refractive index of the cured product is easily adjusted to a desired range and the toughness of the cured product can be enhanced, and thus the connection loss can be suppressed.
When $R^1$ to $R^5$ and $R^7$ to $R^{11}$ are reactive functional groups, a hydrogen atom, a hydroxyl group such as an alcohol, a carboxy group, an aldehyde group, an epoxy group, and the like are suitable. However, in the present aspect, $R^1$ to $R^3$, $R^7$, $R^8$, and $R^{10}$ do not contain a polymerizable alkenyl group as the reactive functional group. This is because, for example, when $R^1$ to $R^3$ are organic groups containing a polymerizable alkenyl group, the coefficient M1 portion and the coefficient M2 portion cannot be distinguished from each other, and therefore, they are defined as described above.
Meanwhile, even when $R^4$ and $R^5$ in the coefficient M2 portion are organic groups containing a polymerizable

alkenyl group, such a problem does not occur, and therefore, R4 and R5 are not subject to this restriction. For the same reason, for the coefficient D1 portion and the coefficient T1 portion, $R^7$, $R^8$, and $R^{10}$ are defined as containing no polymerizable alkenyl group in the present aspect.

As described above, in the organopolysiloxane represented by Formula [1] of the present embodiment, the proportion of the aromatic group relative to the total of all the groups bonded to the silicon atoms is 20 mol% or less. That is, the proportion of the aromatic group in the total of $R^1$ to $R^{11}$ is required to be 20 mol% or less. Here, the aromatic group includes an aromatic structure such as a benzene ring, an aromatic polycycle, and an aromatic heterocycle, may include a substituent structure, an alkylene structure, a salt structure, and the like, and represents a group in which a silicon atom and an aromatic structure may not be directly bonded to each other. In the present embodiment, when the organopolysiloxane contains an excessively large amount of aromatic structures, the cured product to be produced becomes brittle due to the rigidity of the aromatic structures. The proportion of the aromatic group in the total of $R^1$ to $R^{11}$ in the organopolysiloxane is preferably 15 mol% or less, more preferably 10 mol% or less, still more preferably 5 mol% or less, and yet still more preferably 1 mol% or less.

In the present embodiment, the organopolysiloxane represented by Formula [1] may take both an aspect having an aromatic group and an aspect not having an aromatic group at all, as described above. When the organopolysiloxane has an aromatic group, the lower limit of the total of $R^1$ to $R^{11}$ is not limited as long as the effects of the present invention are not impaired, and may be, for example, 0.01 mol% or 0.1 mol%. According to one aspect of the present invention, it is also preferable that the organopolysiloxane should not have any aromatic group bonded to a silicon atom at all, i.e., $R^1$ to $R^{11}$ in the organopolysiloxane should not have an aromatic group. The content of the aromatic group can be confirmed by $^{1}$H-NMR or $^{29}$Si-NMR as described above.

In the organopolysiloxane of the present embodiment, the M unit (optional), the D unit, the T unit, and the Q unit (optional) are preferably randomly polymerized. For example, an aspect in which the D unit and the T unit are not present repeatedly or regularly is preferred. When the respective units are randomly polymerized, toughness is easily imparted to the cured product to be produced.

In general, as the organopolysiloxane suitably used for the optical waveguide, an organopolysiloxane having an aromatic group directly on a silicon atom is used in the core portion in order to achieve a sufficient difference in refractive index between the core portion and the cladding portion. The organopolysiloxane of the present embodiment has the specific structure described above, and thus has a specific effect that the organopolysiloxane can be used as a core member and a cladding member even when the organopolysiloxane does not have an aromatic group directly on a silicon atom.

The organopolysiloxane of the present embodiment may have an aromatic group directly bonded to a silicon atom, but as described above, in order to suppress the connection loss when an optical waveguide is formed, the proportion of the aromatic group in the total of all the groups bonded to the silicon atoms needs to be 20 mol% or less. That is, even when the proportion of the aromatic group is in this range, the organopolysiloxane of the present embodiment can be suitably used as a core member and a cladding member.

The organopolysiloxane of the present embodiment may have a halogen group such as fluorine, but preferably does not have a halogen group. When the organopolysiloxane has no halogen substituent, the refractive index of the cured product produced from the organopolysiloxane having the specific structure can be stably controlled to a desired range.

The organopolysiloxane of the above embodiment is particularly suitable for near-infrared optical waveguide applications. Therefore, in another embodiment of the present invention, an organopolysiloxane for a near-infrared optical waveguide is also provided. The aspects, requirements, and the like of the organopolysiloxane for a near-infrared optical waveguide are as described above for the organopolysiloxane of the first embodiment.

Hereinafter, the term "organopolysiloxane" means both the organopolysiloxane and the organopolysiloxane for a near-infrared optical waveguide.

## Method for Producing Organopolysiloxane

The method for producing the organopolysiloxane of the present embodiment is not particularly limited as long as an organopolysiloxane having an organic group containing a polymerizable alkenyl group and a D unit, in which the proportion of an aromatic group in a total of all groups bonded to silicon atoms is 20 mol% or less, can be produced. Especially, the organopolysiloxane represented by Formula [1] is preferably produced.

For example, any production method such as a method of simultaneously condensing one or more of a disiloxane compound, a disilazane compound, and hydrolyzates thereof, and an alkoxysilane compound and a hydrolyzate and a partially hydrolyzed condensate thereof, a method of condensing a chlorosilane compound and a hydrolyzate and a partially hydrolyzed condensate thereof, a method of ring-opening polymerization of a cyclic siloxane compound, and chain polymerization including anionic polymerization may be used, and a plurality of production methods may be combined.

The method for introducing the polymerizable alkenyl group is not particularly limited, and may be any method

such as a method of simultaneously condensing one or more of an alkoxysilane compound, a disiloxane compound, and a disilazane compound having a polymerizable alkenyl group, and hydrolyzates and partially hydrolyzed condensates thereof, and a method of converting a reactive organic group introduced into organopolysiloxane into a polymerizable alkenyl group by a chemical method, and these methods may be combined.

Hereinafter, in the present embodiment, examples of raw materials that can be used in the production of the organopolysiloxane by hydrolysis condensation are indicated below.

M Unit Source

Examples of the M unit source include trimethylsilanol, trimethylmethoxysilane, hexamethyldisiloxane, hexamethyldisilazane, dimethylsilanol, dimethylmethoxysilane, tetramethyldisiloxane, tetramethyldisilazane, dimethylvinylsilanol, dimethylvinylmethoxysilane, 1,3-divinyltetramethyldisiloxane, 1,3-divinyltetramethyldisilazane, dimethyl(meth)acryloyloxypropylsilanol, dimethyl(meth)acryloyloxypropylmethoxysilane, 1,3-di(meth)acryloyloxypropyltetramethyldisiloxane, dimethylglycidyloxypropylmethoxysilane, 1,3-bis(3-glycidyloxypropyl)tetramethyldisiloxane, 3-(meth)acryloyloxypropyldimethylsilanol, 3-(meth)acryloyloxypropyldimethylmethoxysilane, 1,3-bis((meth)acryloyloxypropyl)-1,1,3,3-tetramethyldisiloxane, tetramethyldisiloxane, methoxytriphenylsilane, triphenylsilanol, 1,3-diphenyltetramethyldisiloxane, 1,3-diphenyltetramethyldisilazane, dimethylphenylsilanol, dimethylmethoxyphenylsilane, 1,4-bis(dimethylmethoxysilyl)benzene, and 1,4-bis(dimethylethoxysilyl)benzene. Among the compounds listed above, for compounds containing a silanol hydroxyl group or an alkoxy group, a group of compounds having a halogen bonded thereto instead of the silanol hydroxyl group or the alkoxy group can be used. For the above reasons, it is preferable to use a compound including no aromatic structure, and hexamethyldisiloxane can be particularly suitably used.

D Unit Source

Examples of the D unit source include dimethyldisilanol, dimethyldimethoxysilane, diphenyldisilanol, diphenyldimethoxysilane, 3-(meth)acryloyloxypropyldimethoxymethylsilane, 3-glycidoxypropylmethyldimethoxysilane, methyldimethoxyphenylsilane, diethoxymethylphenylsilane, methylphenyldisilanol, 1,4-bis(methyldimethoxysilyl)benzene, 1,4-bis(methyldiethoxysilyl)benzene, and dimethoxy(methyl)(3,3,3-trifluoropropyl)silane. A group of compounds having a halogen bonded thereto instead of the silanol hydroxyl group or alkoxy group of the compounds listed above, and polymers thereof can be used. For the above reasons, it is preferable to use a compound including no aromatic structure, and particularly, dimethyldimethoxysilane can be suitably used.

T Unit Source

Examples of the T unit source include trimethoxysilanes modified with a C1 to C20 longchain alkoxy group, such as trimethoxysilane, methyltrimethoxysilane, ethyltrimethoxysilane, propyltrimethoxysilane, and hexyltrimethoxysilane, decyltrimethoxysilane; vinyltrimethoxysilane, phenyltrimethoxysilane, 3,3,3-trifluoropropyltrimethoxysilane, 3-(meth)acryloyloxypropyltrimethoxysilane, 8-(meth)acryloyloxyoctyltrimethoxysilane, 1,4-bis(trimethoxysilyl)benzene, p-styryltrimethoxysilane, 3-glycidyloxypropyltrimethoxysilane, 8-glycidyloxyoctyltrimethoxysilane, and 2-(3,4-epoxycyclohexyl)ethyltrimethoxysilane. In addition to these methoxysilane compounds, alkoxysilane compounds such as ethoxysilane, silanol compounds, chlorosilane compounds, hydrosilylsilane compounds, and polymers thereof can be used. For the above reasons, it is preferable to use a compound including no aromatic structure, and particularly, 3-methacryloyloxypropyltrimethoxysilane, 8-methacryloyloxyoctyltrimethoxysilane, 3-acryloyloxypropyltrimethoxysilane, and 8-acryloyloxyoctyltrimethoxysilane can be suitably used.

Q Unit Source

Examples of the Q unit source include alkoxysilanes such as tetrachlorosilane, tetramethoxysilane, tetraethoxysilane, tetraisopropoxysilane, tetrapropoxysilane, tetrabutoxysilane, tetrapentyloxysilane, tetraphenyloxysilane, trimethoxymonoethoxysilane, dimethoxydiethoxysilane, triethoxymonomethoxysilane, trimethoxymonopropoxysilane, monomethoxytributoxysilane, monomethoxytripentyloxysilane, monomethoxytriphenyloxysilane, dimethoxydipropoxysilane, tripropoxymonomethoxysilane, trimethoxymonobutoxysilane, dimethoxydibutoxysilane, triethoxymonopropoxysilane, diethoxydipropoxysilane, tributoxymonopropoxysilane, dimethoxymonoethoxymonobutoxysilane, diethoxymonomethoxymonobutoxysilane, diethoxymonopropoxymonobutoxysilane, dipropoxymonomethoxymonoethoxysilane, dipropoxymonomethoxymonobutoxysilane, dipropoxymonoethoxymonobutoxysilane, dibutoxymonomethoxymonoethoxysilane, dibutoxymonoethoxymonopropoxysilane, and monomethoxymonoethoxymonopropoxymonobutoxysilane, and aryloxysilane, Methyl Silicates MS51, MS56, MS57, and MS60 available from Mitsubishi Chemical Corporation as tetramethoxysilane oligomers, and Ethyl Silicate Oligomers ES40 and ES48 available from Tama Chemicals Co., Ltd. as

tetraethoxysilane oligomers. In particular, Methyl Silicate MS51 is suitable.

One type of each of the M, D, T, and Q unit sources may be used alone, or two or more types thereof may be used in combination.

As a catalyst for hydrolysis condensation of these silicon raw materials, an acid catalyst, a base catalyst, or an inorganic salt can be used. In particular, an acid catalyst can be suitably used.

Examples of the acid catalyst include hydrochloric acid, sulfuric acid, trifluoroacetic acid, acetic acid, methacrylic acid, and acrylic acid. In particular, hydrochloric acid can be suitably used.

Examples of the base catalyst include ammonia, hexamethyldisilazane, triethylamine, tetraethylammonium hydroxide, diazabicycloundecene, potassium hydroxide, sodium hydroxide, barium hydroxide, potassium carbonate, and sodium carbonate. Potassium hydroxide is particularly suitable.

Examples of the inorganic salt include sodium chloride, potassium chloride, magnesium chloride, calcium chloride, sodium bromide, potassium bromide, magnesium bromide, and calcium bromide. Sodium chloride is particularly suitable.

Examples of the solvent used in the hydrolysis condensation include tetrahydrofuran, toluene, methanol, ethanol, isopropanol, hexane, and heptane. In particular, tetrahydrofuran is preferred. Depending on the solubility of the product, two or more solvents may be used, and a mixed liquid of toluene and methanol or a mixed liquid of tetrahydrofuran and methanol is particularly preferable.

The alkoxy group or silanol group remaining without hydrolysis condensation may be substituted with an organic acid or an alcohol, if necessary. Examples of the organic acid that can be used include acetic acid, acrylic acid, and methacrylic acid, examples of the alcohol that can be used include methanol, ethanol, propanol, butyl alcohol, pentanol, hexanol, heptanol, and structural isomers thereof as alcohols containing no polymerizable alkenyl group, 2-hydroxyethyl acrylate and 2-hydroxyethyl methacrylate can be used as the alcohol containing a polymerizable alkenyl group, and 2-hydroxyethyl acrylate and 2-hydroxyethyl methacrylate are preferable from the viewpoint of stability.

When the organopolysiloxane has a rigid structure such as a complete cage silsesquioxane, the cured product is hard and brittle, and therefore the organopolysiloxane preferably does not have a complete cage structure. The silsesquioxane may be any silsesquioxane as long as it is not a complete cage silsesquioxane, and may include, for example, a random structure or ladder structure as a higher-order structure within such a range that the effects of the present invention are not impaired.

Water

The amount of water used for the hydrolysis is preferably 0.5 equivalents or more, more preferably 0.8 equivalents or more, and still more preferably 1.1 equivalents or more, relative to the total amount of alkoxy groups contained in the MDTQ unit sources. The water is not particularly limited, and may be water contained in commercially available hydrochloric acid or the like, or water purified by distillation or an ion exchange resin may be used.

Organopolysiloxane-Containing Resin Composition

The organopolysiloxane-containing resin composition of the present embodiment is used for forming a near-infrared optical waveguide, and the composition may contain, in addition to the organopolysiloxane described above, a monofunctional polymerizable alkenyl compound, a polyfunctional polymerizable alkenyl compound, and/or an alkenyl-based polymer, etc., within such a range that the properties of the cured product produced from the composition, as described below, are not impaired.

The composition may further contain a polymerization initiator for polymerizing and easily curing the organopolysiloxane and the polymerizable alkenyl compound. Although the organopolysiloxane or the organopolysiloxane-containing resin composition can be cured by electron beam irradiation or the like without using a polymerization initiator, a large amount of energy is required for curing, and therefore, in a preferred aspect of the present embodiment, the organopolysiloxane-containing resin composition contains at least a polymerization initiator in addition to the organopolysiloxane.

The composition of the present embodiment may contain a chain transfer agent, an antioxidant, an ultraviolet absorber, a light stabilizer, a leveling agent, a rheology modifier, an adhesion aid such as a silane coupling agent, an additional component such as a dye, an antifoaming agent, or a sensitizer, a solvent, or the like within such a range that the properties of the cured product, as described below, are not impaired.

The organopolysiloxane-containing resin composition (curable composition) is particularly suitable for near-infrared optical waveguide applications. Therefore, in another embodiment of the present invention, an organopolysiloxane-containing resin composition for a near-infrared optical waveguide is also provided. The respective aspects, requirements, and the like of the organopolysiloxane-containing resin composition for a near-infrared optical waveguide are as described above for the organopolysiloxane-containing resin composition.

Hereinafter, the term "organopolysiloxane-containing resin composition" means both the organopolysiloxane-containing resin composition and the organopolysiloxane-containing resin composition for a near-infrared optical waveguide.

Hereinafter, components that may be contained in the organopolysiloxane-containing resin composition will be described.

Monofunctional Polymerizable Alkenyl Compound

Specific examples of the monofunctional polymerizable alkenyl compound include (meth)acrylates containing a carboxy group such as (meth)acrylic acid, 2-(meth)acryloyloxyethyl succinate, 2-(meth)acryloyloxyethyl maleate, 2-(meth)acryloyloxyethyl phthalate, and 2-(meth)acryloyloxyethyl hexahydrophthalate;

(meth)acrylates having a hydroxyl group such as 2-hydroxyethyl (meth)acrylate, 2-hydroxypropyl (meth)acrylate, 2-hydroxybutyl (meth)acrylate, 4-hydroxybutyl (meth)acrylate, and 6-hydroxyhexyl (meth)acrylate;
alkyl (meth)acrylates such as methyl (meth)acrylate, ethyl (meth)acrylate, propyl (meth)acrylate, n-butyl (meth)acrylate, i-butyl (meth)acrylate, tert-butyl (meth)acrylate, pentyl (meth)acrylate, heptyl (meth)acrylate, 2-ethylhexyl (meth)acrylate, n-octyl (meth)acrylate, isooctyl (meth)acrylate, n-nonyl (meth)acrylate, isononyl (meth)acrylate, decyl (meth)acrylate, lauryl (meth)acrylate, tridecyl (meth)acrylate, and stearyl (meth)acrylate;
(meth)acrylates containing an alicyclic structure such as cyclohexyl (meth)acrylate, dicyclopentenyl (meth)acrylate, 2-dicyclopentenoxyethyl (meth)acrylate, isobornyl (meth)acrylate, dicyclopentanyl (meth)acrylate, adamantyl (meth)acrylate, and 4-tert-butylcyclohexyl (meth)acrylate;
(meth)acrylates containing an aromatic ring structure such as phenyl (meth)acrylate, benzyl (meth)acrylate, phenoxyethyl (meth)acrylate, phenoxydiethylene glycol (meth)acrylate, phenoxypolyethylene glycol (meth)acrylate, nonylphenoxypolyethylene glycol (meth)acrylate, phenoxypolypropylene glycol (meth)acrylate, phenylphenyl (meth)acrylate, phenylphenoxyethyl (meth)acrylate, phenoxybenzyl (meth)acrylate, phenylbenzyl (meth)acrylate, naphthyl (meth)acrylate, and (1-naphthyl)methyl (meth)acrylate;
(meth)acrylates containing a heterocyclic structure such as tetrahydrofurfuryl (meth)acrylate, glycidyl (meth)acrylate, and (meth)acryloylmorpholine;
alkoxy (meth)acrylates such as methoxyethyl (meth)acrylate, ethoxyethyl (meth)acrylate, and butoxyethyl (meth)acrylate;
3-(meth)acryloxypropyltrimethoxysilane, 3-(meth)acryloxypropyltriethoxysilane, 2-(meth)acryloyloxyethyl acid phosphate, trifluoroethyl (meth)acrylate, heptadecafluorodecyl (meth)acrylate, and 2-(meth)acryloyloxyethyl isocyanate;
styrene derivatives such as styrene, $\alpha$-methylstyrene, 2-vinylpyridine, 4-vinylpyridine, 1,1-diphenylethylene, and aromatic ring hydrogen substitution products thereof; and
vinyl compounds such as vinyl acetate, vinyl octanoate, vinyl decanoate, vinyl hexanoate, acrylonitrile, and vinyl benzoate.

Since the cured product has a high refractive index and is brittle, it is preferable to use a compound including no aromatic structure.

Polyfunctional Polymerizable Alkenyl Compound

Specific examples of the polyfunctional polymerizable alkenyl compound include polyfunctional monomers such as: alkylene glycol di(meth)acrylates such as ethylene glycol di(meth)acrylate, propylene glycol di(meth)acrylate, butylene glycol di(meth)acrylate, 1,6-hexanediol di(meth)acrylate, 1,9-nonanediol di(meth)acrylate, 1,10-decanediol di(meth)acrylate, and neopentyl glycol di(meth)acrylate;

polyalkylene glycol di(meth)acrylates such as polyethylene glycol di(meth)acrylate, polypropylene glycol di(meth)acrylate, and polybutylene glycol di(meth)acrylate;
di(meth)acrylates containing an alicyclic structure such as cyclohexanedimethanol di(meth)acrylate, tricyclodecane dimethanol di(meth)acrylate, ethoxylated hydrogenated bisphenol A di(meth)acrylate, propoxylated hydrogenated bisphenol A di(meth)acrylate, and adamantanediol di(meth)acrylate;
bifunctional (meth)acrylates such as polycarbonatediol di(meth)acrylate, polyesterdiol di(meth)acrylate, ethoxylated bisphenol A di(meth)acrylate, propoxylated bisphenol A di(meth)acrylate, 9,9-bis(4-acryloyloxyethoxyphenyl)fluorene, and polyurethane di(meth)acrylate;
trifunctional (meth)acrylates such as trimethylolpropane tri(meth)acrylate, ethoxylated isocyanuric acid tri(meth)acrylate, and $\varepsilon$-caprolactone-modified tris((meth)acryloyloxyethyl)isocyanurate;

tetrafunctional (meth)acrylates such as ditrimethylolpropane tetra(meth)acrylate;
pentafunctional (meth)acrylates such as dipentaerythritol penta(meth)acrylate; and
hexafunctional (meth)acrylates such as dipentaerythritol hexa(meth)acrylate; and
1,4-divinylbenzene, and 1,3-divinylbenzene.

Since the cured product has a high refractive index and is brittle, it is preferable to use a compound including no aromatic structure.

Alkenyl-Based Polymer

The alkenyl-based polymer is a polymer containing 50 mass% or more of an alkenyl monomer unit in the polymer. In the present specification, the term "unit" means a repeating unit constituting a polymer. The alkenyl-based polymer may be monofunctional or polyfunctional. The cured product has a high refractive index and is brittle, and therefore, the polymer preferably does not include an aromatic structure.

The alkenyl monomer unit contained in the alkenyl-based polymer may be one type or two or more types.

The polymerization method for producing the alkenyl-based polymer is also not particularly limited, and polymerization can be performed by a known method such as a solution polymerization method, a suspension polymerization method, an emulsion polymerization method, or a partial polymerization method. In the present embodiment, the suspension polymerization method is preferable because the polymerization reaction can be relatively easily controlled and the produced polymer can be relatively easily separated.

As the alkenyl-based polymer, a polymer modified by introducing a functional group containing a double bond such as a (meth)acryloyl group or a vinyl group into a side chain by chemical modification may be used. As the chemical modification method, for example, a reaction between a carboxy group and a glycidyl group or a reaction between a hydroxyl group and an isocyanate group can be used.

In the case of using a reaction between a carboxy group and a glycidyl group as the chemical modification method, for example, a method of producing an alkenyl-based polymer containing an alkenyl monomer unit having a carboxy group and reacting the produced alkenyl-based polymer with a compound having a glycidyl group and a double bond, such as glycidyl (meth)acrylate, is exemplified.

In the reaction of the alkenyl-based polymer containing an alkenyl-based monomer unit having a carboxy group with the compound having a glycidyl group and a double bond, a reaction catalyst is preferably used for shortening the reaction time. Examples of the reaction catalyst include quaternary ammonium salts such as tetrabutylammonium bromide, quaternary phosphonium salts such as ethyltriphenylphosphonium bromide, and phosphine-based compounds such as triphenylphosphine. From the viewpoint that the organopolysiloxane-containing resin composition of the present embodiment is less likely to be colored, a quaternary ammonium salt is particularly preferred.

The weight average molecular weight (Mw) of the alkenyl-based polymer is preferably from 5000 to 500000, more preferably from 10000 to 200000, and still more preferably from 20000 to 150000. When the weight average molecular weight is 5000 or more, the strength of the cured product becomes good. When the weight average molecular weight is 500000 or less, the viscosity of the organopolysiloxane-containing resin composition of the present embodiment is lowered, and therefore, workability becomes good.

Polymerization Initiator

Examples of the polymerization initiator include a photopolymerization initiator, a thermal polymerization initiator, and a peroxide used in redox polymerization. The type of polymerization initiator can be appropriately selected depending on the polymerization method.

Photopolymerization Initiator

The photopolymerization initiator is a radical polymerization initiator used in photopolymerization. Specific examples of the photopolymerization initiator include benzophenone-type compounds such as benzophenon, 4-methylbenzophenon, 2,4,6-trimethylbenzophenon, methyl 2-benzoylbenzoate, and 4-phenylbenzophenone; anthraquinonetype compounds such as tert-butylanthraquinone and 2-ethylanthraquinone; alkylphenone-type compounds such as 2-hydroxy-2-methyl-1-phenylpropan-1-one, oligo{2-hydroxy-2-methyl-1-[4-(1-methylvinyl)phenyl]propanone}, benzyl dimethyl ketal, 1-hydroxycyclohexyl phenyl ketone, benzoin methyl ether, 2-methyl-[4-(methylthio)phenyl]-2-morpholino-1-propanone, and 2-hydroxy-1-{4-[4-(2-hydroxy-2-methylpropionyl)benzyl]phenyl}-2-methylpropan-1-one; thioxanthone-type compounds such as 2-benzyl-2-dimethylamino-4'-morpholinobutyrophenone, diethylthioxanthone, and isopropylthioxanthone; acylphosphine oxide-type compounds such as 2,4,6-trimethylbenzoyldiphenylphosphine oxide, bis(2,6-dimethoxybenzoyl)-2,4,4-trimethylpentylphosphine oxide, and bis(2,4,6-trimethylbenzoyl)phenylphosphine

oxide; phenylglyoxlate-type compounds such as phenylglyoxilic acid methyl ester; oxime-ester-type compounds such as N-acetoxy-N-{4-acetoxyimino-4-[9-ethyl-6-(o-toluoyl)-9H-carbazol-3-yl]butan-2-yl}acetamide, N-acetoxy-N-{3-(acetoxyimino)-3-[9-ethyl-6-(1-naphthoyl)-9H-carbazol-3-yl]-1-methylpropyl}acetamide, methyl 4-acetoxyimino-5-[9-ethyl-6-(2-methylbenzoyl)-9H-carbazol-3-yl]-5-oxopentanoate, and methyl 4-acetoxyimino-5-oxo-5-(4-(phenylthio)phenyl)pentanoate, and combinations thereof.

Among these, alkylphenone-type compounds are preferred, and 2-hydroxy-2-methyl-1-phenylpropan-1-one or 1-hydroxycyclohexyl phenyl ketone is more preferred, from the viewpoint that coloration of the cured product can be suppressed. An acylphosphine oxide-type compound is preferable from the viewpoint of easily curing the inside of the cured product sufficiently, and 2,4,6-trimethylbenzoyldiphenylphosphine oxide is more preferable from the viewpoint that coloration of the cured product can be suppressed. Bis(2,4,6-trimethylbenzoyl)phenylphosphine oxide and methyl 4-acetoxyimino-5-oxo-5-(4-(phenylthio)phenyl)pentanoate, which have high sensitivity to light on a longer wavelength side, are more preferable. From the viewpoint of high reactivity to light around a wavelength of 365 nm, 2-benzyl-2-dimethylamino-4'-morpholinobutyrophenone is also preferable. One type of these photopolymerization initiators may be used alone, or two or more types thereof may be used in combination.

In the present embodiment, when the organopolysiloxane-containing curable resin composition (hereinafter may be referred to simply as "curable resin composition") is cured by photopolymerization to produce a cured product, the wavelength of light to be applied to the curable resin composition is not particularly limited, but it is preferable to apply ultraviolet light having a wavelength of from 200 to 500 nm. Specific examples of the light source of ultraviolet light include an ultra-high pressure mercury lamp, a high pressure mercury lamp, a metal halide lamp, a high power metal halide lamp, a UV-LED lamp, a chemical lamp, and a black light.

After the curable resin composition is photopolymerized, after-curing may be further performed. By performing the after-curing, the amount of unreacted polymerizable alkenyl groups remaining in the cured product can be reduced, and the strength of the cured product can be further enhanced. Examples of the conditions for the after-curing include a temperature of from 50°C to 200°C for from several tens of seconds to 60 minutes, or a temperature of from 80°C to 150°C for from several tens of seconds to 60 minutes.

Thermal Polymerization Initiator

The thermal polymerization initiator is a radical polymerization initiator used in thermal polymerization. Examples of the thermal polymerization initiator include organic peroxides and azo compounds.

Specific examples of the organic peroxide include ketone peroxides such as methyl ethyl ketone peroxide; peroxyketals such as 1,1-di(tert-hexylperoxy)-3,3,5-trimethylcyclohexane, 1,1-di(tert-hexylperoxy)cyclohexane, and 1,1-di(tert-butylperoxy)cyclohexane; hydroperoxides such as 1,1,3,3-tetramethylbutyl hydroperoxide, cumene hydroperoxide, and p-menthane hydroperoxide; dialkyl peroxides such as dicumyl peroxide and di-tert-butyl peroxide; diacyl peroxides such as dilauroyl peroxide and dibenzoyl peroxide; peroxydicarbonates such as di(4-tert-butylcyclohexyl) peroxydicarbonate and di(2-ethylhexyl) peroxydicarbonate; and peroxyesters such as tert-butylperoxy-2-ethyl hexanoate, tert-hexylperoxyisopropyl monocarbonate, tert-butylperoxy benzoate, and 1,1,3,3-tetramethylbutyl-2-ethyl hexanoate.

Specific examples of the azo compound include 2,2'-azobisisobutyronitrile, 2,2'-azobis(2-methylbutyronitrile), 2,2'-azobis(2,4-dimethylvaleronitrile), 1,1'-azobis-1-cyclohexanecarbonitrile, dimethyl-2,2'-azobisisobutyrate, 4,4'-azobis-4-cyanovaleric acid, and 2,2'-azobis-(2-amidinopropane) dihydrochloride.

One type of these thermal polymerization initiators may be used alone, or two or more types thereof may be used in combination. As the thermal polymerization initiator, an organic peroxide is preferred from the viewpoint that bubbles are less likely to be generated in the cured product. In consideration of the balance between a curing time and a pot life of the curable resin composition, the 10-hour half-life temperature of the organic peroxide is preferably from 35 to 80°C, more preferably from 40 to 75°C, and still more preferably from 45 to 70°C. When the 10-hour half-life temperature is 35°C or higher, the curable resin composition is less likely to gel at normal temperature, and the pot life is good. Meanwhile, when the 10-hour half-life temperature is 80°C or lower, the curing time of the curable resin composition can be shortened.

Examples of such organic peroxides include 1,1,3,3-tetramethylbutylperoxy-2-ethylhexanoate, tert-butylperoxy-2-ethylhexanoate, and di(4-tert-butylcyclohexyl)peroxydicarbonate. Examples of commercially available products of 1,1,3,3-tetramethylbutylperoxy-2-ethylhexanoate include PEROCTA O (trade name, available from NOF Corporation, 10-hour half-life temperature: 65.3°C). Examples of commercially available products of tert-butylperoxy-2-ethylhexanoate include PERBUTYL O (trade name, available from NOF Corporation, 10-hour half-life temperature: 72.1°C). Examples of commercially available products of di(4-tert-butylcyclohexyl)peroxydicarbonate include PEROYL TCP (trade name, available from NOF Corporation, 10-hour half-life temperature: 40.8°C).

In the case of producing a cured product by curing the curable resin composition through thermal polymerization, curing conditions are not particularly limited, but, from the viewpoint of easily producing a resin for an optical member in which coloration is suppressed, the curing temperature is preferably from 40 to 200°C, and more preferably from 60 to

150°C. The curing time (heating time) varies depending on the curing temperature, and is preferably from 1 to 120 minutes, and more preferably from 1 to 60 minutes.

After the curable resin composition is thermally polymerized, it is preferable to further perform after-curing. Examples of the conditions for the after-curing include a temperature of from 50°C to 200°C for from several tens of seconds to 60 minutes, or a temperature of from 80°C to 150°C for from several tens of seconds to 60 minutes.

Redox Polymerization

In the redox polymerization, a redox-based polymerization initiator is usually used. The redox-based polymerization initiator is a polymerization initiator using a peroxide and a reducing agent in combination. Examples of the peroxide used in the redox polymerization include dibenzoyl peroxide and hydroperoxide. One type of these peroxides may be used alone, or two or more types thereof may be used in combination. When the above peroxide is used as a redox-based polymerization initiator, an example of a combination with a reducing agent is as follows.

(1) A combination of dibenzoyl peroxide (peroxide) and an aromatic tertiary amine (reducing agent) such as N,N-dimethylaniline, N,N-dimethyl-p-toluidine, or N,N-bis(2-hydroxypropyl)-p-toluidine.
(2) A combination of a hydroperoxide (peroxide) and a metal soap (reducing agent).
(3) A combination of a hydroperoxide (peroxide) and a thiourea (reducing agent).

In the case of producing a cured product by curing the curable resin composition through redox polymerization, the curable resin composition can be cured at a temperature of from 5 to 40°C by using a redox-based polymerization initiator. The curing temperature is preferably from 15 to 40°C from the viewpoint that the amount of unreacted (meth) acryloyl groups remaining in the resulting resin for an optical member can be reduced and that the strength of the resin for an optical member can be further increased.

From the viewpoint that the curable resin composition is less likely to gel and can be stably handled, a method of performing curing by a procedure of dissolving the reducing agent in the curable resin composition in advance and adding a peroxide thereto is preferable.

When the curable resin composition is cured, it is preferable to cure the curable resin composition in a sealed state in order to suppress curing inhibition by oxygen. Examples of a sealing method include a method of sandwiching the curable resin composition between glass plates or PET films.

Chain Transfer Agent

When the curing reaction of the curable resin composition is performed in air, active radicals are trapped as peroxide radicals by oxygen, and the polymerization is inhibited, but the polymerization inhibition by oxygen can be suppressed by adding a chain transfer agent that provides hydrogen.

Examples of the chain transfer agent include thiol compounds such as: mercaptocarboxylic acid esters such as methyl mercaptoacetate, methyl 3-mercaptopropionate, 2-ethylhexyl 3-mercaptopropionate, 3-methoxybutyl 3-mercaptopropionate, n-octyl 3-mercaptopropionate, stearyl 3-mercaptopropionate, 1,4-bis(3-mercaptopropionyloxy)butane, 1,4-bis(3-mercaptobutyryloxy)butane, trimethylolethane tris(3-mercaptopropionate), trimethylolethane tris(3-mercaptobutyrate), trimethylolpropane tris(3-mercaptopropionate), trimethylolpropane tris(3-mercaptobutyrate), pentaerythritol tetrakis(3-mercaptopropionate), pentaerythritol tetrakis(3-mercaptobutyrate), dipentaerythritol hexakis(3-mercaptopropionate), dipentaerythritol hexakis(3-mercaptobutyrate), tris[2-(3-mercaptopropionyloxy)ethyl] isocyanurate, and tris [2-(3-mercaptobutyryloxy)ethyl] isocyanurate; alkylthiols such as ethanethiol, 2-methylpropane-2-thiol, n-dodecanethiol, 2,3,3,4,4,5-hexamethylhexane-2-thiol (tert-dodecanethiol), ethane-1,2-dithiol, propane-1,3-dithiol, and benzylthiol; aromatic thiols such as benzenethiol, 3-methylbenzenethiol, 4-methylbenzenethiol, naphthalene-2-thiol, pyridine-2-thiol, benzimidazole-2-thiol, and benzothiazole-2-thiol; mercaptoalcohols such as 2-mercaptoethanol and 4-mercapto-1-butanol; and silane-containing thiols such as 3-(trimethoxysilyl)propane-1-thiol and 3-(triethoxysilyl)propane-1-thiol. Among these, from the viewpoint of the reactivity and storage stability of the curable composition, a secondary thiol compound is preferably used.

When the chain transfer agent is added, one type of the chain transfer agents may be used alone, or two or more types thereof may be used in combination. The amount of the chain transfer agent to be added is preferably from 0.01 to 20 parts by mass, more preferably from 0.1 to 10 parts by mass, and still more preferably from 0.5 to 10 parts by mass relative to 100 parts by mass of the total amount of polymerizable components. In the case of using a mixture of two or more types, the total amount of the chain transfer agents is within the above range.

Solvent

The curable resin composition of the present embodiment may contain a solvent for the purpose of diluting the organopolysiloxane and other ingredients. The type of the solvent is not particularly limited as long as the physical properties required of the organopolysiloxane and the cured product of the curable resin composition are not impaired. Examples of the solvent that may be used include aromatic hydrocarbons having good solubility (e.g., toluene, xylene, ethyl benzoate, ethylbenzene, and benzyl alcohol), ketones (e.g., acetone, methyl ethyl ketone, methyl isobutyl ketone, diisobutyl ketone, cyclohexanone, and diacetone alcohol), esters (e.g., methyl acetate, ethyl acetate, butyl acetate, sec-butyl acetate, methoxybutyl acetate, amyl acetate, normal propyl acetate, ethyl lactate, methyl lactate, butyl lactate, propylene glycol monomethyl ether acetate, and γ-butyrolactone), ethers (e.g., isopropyl ether, ethylene glycol monomethyl ether, propylene glycol monomethyl ether, ethylene glycol monobutyl ether, 1,4-dioxane, methyl-tert-butyl ether, and tetrahydrofuran), alcohols (e.g., methanol, ethanol, normal propanol, isopropanol, butanol, sec-butanol, tert-butanol, and normal pentanol), halogen-based solvents (e.g., methylene chloride, trichloroethylene, tetrachloroethylene, bromopropane, and chloroform), and others (e.g., dimethyl sulfoxide, N,N-dimethylformamide, and water). Two or more types of solvents may be used.

The content of the solvent in the curable resin composition is not particularly limited as long as the physical properties required of the cured product of the curable resin composition are not impaired. In a case where it is desired to reduce the viscosity while suppressing a volatile content to a small amount, the content is preferably more than 0 mass% and 25 mass% or less relative to the entire curable resin composition. In the case of producing a thin film cured product, the content is preferably 75 mass% or more and less than 100 mass% relative to the entire organopolysiloxane or curable resin composition.

Antioxidant

The curable resin composition preferably further contains an antioxidant. When the curable resin composition contains an antioxidant, coloring of the cured product due to heat, such as heating during soldering of the cured product or heat generation of the device, can be suppressed.

Specific examples of the antioxidant include phenolic antioxidants such as 2,6-di-tertbutylphenol, 2,6-di-tert-butyl-p-cresol, n-octadecyl-3-(3',5'-di-tert-butyl-4'-hydroxyphenyl) propionate, tetrakis-[methylene-3-(3',5'-di-tert-butyl-4'-hydroxyphenyl)propionate]methane, triethylene glycol bis[3-(3-tert-butyl-5-methyl-4-hydroxyphenyl)propionate], and 1,6-hexanediol bis[3-(3,5-di-tert-butyl-4-hydroxyphenyl)propionate]; phosphorus-based antioxidants such as triphenyl phosphite, trisisodecyl phosphite, tristridecyl phosphite, tris(2,4-di-tert-butylphenyl) phosphite, and tetra(C12 to 15 alkyl)-4,4'-isopropylidenediphenyl diphosphite; and sulfur-based antioxidants such as dilauryl-3,3'-thiodipropionate, ditridecyl-3,3'-thiodipropionate, dimyristyl-3,3'-thiodipropionate, distearyl-3,3'-thiodipropionate, and pentaerythritol tetrakis(β-laurylthiopropionate). One type of these antioxidants may be used alone, or two or more types thereof may be used in combination.

Additional Component

The curable resin composition of the present embodiment may contain an additional component such as a filler, a curing control agent, or a viscosity modifier. These components can be appropriately contained within such a range that the heat resistance and refractive index of the cured product of the organopolysiloxane-containing curable resin composition of the present embodiment are not affected.

The organopolysiloxane-containing resin composition (curable composition) of the present embodiment is particularly suitable for near-infrared optical waveguide applications. Therefore, in another embodiment of the present invention, an organopolysiloxane composition for a near-infrared optical waveguide is also provided. The respective aspects, requirements, and the like of the organopolysiloxane composition for a near-infrared optical waveguide are as described above for the organopolysiloxane composition.

In the present specification, the term "organopolysiloxane composition" means both an organopolysiloxane composition and an organopolysiloxane composition for a near-infrared optical waveguide.

Cured Product of First Aspect

A first aspect of the present invention (hereinafter may be referred to as the present first aspect) provides a cured product produced by curing the organopolysiloxane-containing resin composition of the first embodiment described above by heat or light.

The curing conditions for the organopolysiloxane-containing resin composition of the present embodiment are not particularly limited, and the resin composition can be cured under conditions appropriately adopted for curing of a

silicone resin depending on the type of the polymerization initiator and the like.

Cured Product of Second Aspect

A second aspect of the present invention (hereinafter may be referred to as the present second aspect) provides a cured product including a crosslinked structure derived from an organic group containing a polymerizable alkenyl group and a siloxane unit (D unit) represented by $SiO_{2/2}$, the cured product having a refractive index of 1.400 or more and 1.500 or less at a wavelength of 1300 nm.

For applications of the optical waveguide having a large difference in refractive index between a core portion and a cladding portion for a multimode, a near-infrared optical waveguide formed of an organopolysiloxane cured product having an aromatic group and having a refractive index of more than 1.5 in a near-infrared wavelength region has been reported. However, the present inventors have found that when the refractive index of a cured product produced by curing a resin composition containing a specific organopolysiloxane at a wavelength in the near-infrared region is from 1.400 to 1.500, the connection loss of the near-infrared optical waveguide is reduced. In the present second aspect, the "transmission loss" and "connection loss" of the optical waveguide are defined as described above.

Although not bound by a specific theory, the following is considered as to the influence of the refractive index of the cured product used for a near-infrared optical waveguide.

That is, it is considered that when the refractive index in the near-infrared wavelength region of the cured product produced by curing the composition containing the organopolysiloxane is from 1.400 to 1.500, the cured product has few rigid structures derived from aromatic structures or the like included therein, has toughness, and is less likely to crack, and the end face when the optical waveguide formed of the cured product is cut is less likely to be roughened. It is considered that suppression of the roughness of the end face of the waveguide suppresses light scattering and reduces the connection loss.

Since the cured product of the present second aspect has a refractive index in the near-infrared wavelength region of from 1.400 to 1.500, the cured product has few rigid structures derived from an aromatic structure or the like included therein, and the roughness of the end face of the optical waveguide formed of the cured product is suppressed, whereby light scattering is suppressed, and the connection loss can be suppressed. Further, the optical waveguide having a core formed of the cured product has a small difference in refractive index from the core of the near-infrared single-mode quartz-based optical fiber, and interface reflection is suppressed, which also leads to a reduction in connection loss.

In applications of an optical waveguide for a single mode, the difference in refractive index between the core portion and the cladding portion constituting the optical waveguide needs to be about from 0.01 to 0.02, and, in the applications, the refractive index of the cladding portion is also required to be about from 1.4 to 1.5 relative to the core portion having a refractive index of from 1.4 to 1.5. Therefore, the cured product of the present second aspect is also suitable as a cladding material for a core having a refractive index of from 1.4 to 1.5 in the applications of the optical waveguide for a single mode.

In the present second aspect, the refractive index of the cured product is from 1.400 to 1.500, preferably from 1.420 to 1.490, and more preferably from 1.430 to 1.480 at 589 nm and 1300 nm.

The cured product of the present second aspect is preferably obtained by curing an organopolysiloxane-containing resin composition containing the organopolysiloxane of the present embodiment 1. Examples of the organopolysiloxane, the method for producing an organopolysiloxane, the organopolysiloxane-containing resin composition (curable resin composition) containing a monofunctional polymerizable alkenyl compound, a polyfunctional polymerizable alkenyl compound, and/or an alkenyl-based polymer, and the like, and additional components, and the curing conditions for the composition can include those described above, and preferred ones and preferred combinations are similarly employed in the present second aspect.

Properties of Cured Product

The cured products of the present first aspect and second aspect (hereinafter may be referred to as "both the aspects"), which are cured products produced by curing an organopolysiloxane-containing resin composition containing an organopolysiloxane, which has an organic group containing a polymerizable alkenyl group and a siloxane unit (D unit) represented by $SiO_{2/2}$ and having a proportion of an aromatic group in all groups bonded to silicon atoms of 20 mol% or less, in the manner as described above, have the following properties.

• Heat Resistance

A cured product having a high reflow resistance, in which the 5% weight loss temperature is preferably 330°C or higher, more preferably 333°C or higher, and still more preferably 340°C or higher, can be produced. The high reflow resistance can prevent an increase in light propagation loss due to high-temperature solder reflow at the time of mounting

on an electronic component or the like. The weight loss temperature is measured by a method described in Examples described below.

• Refractive Index

When the cured product is used as a core material and/or a cladding material of a near-infrared optical waveguide, and the cured product has a refractive index at 589 nm and 1300 nm in a range of from 1.400 to 1.500, preferably from 1.420 to 1.490, and more preferably from 1.430 to 1.480, the content of rigid aromatic groups contained in the cured product is low, toughness derived from the D unit included in the cured product is exhibited, roughness of the end face when the waveguide is cut is suppressed, light scattering at the end face portion is little, and the connection loss is reduced. Further, when the refractive index of the core material of the near-infrared optical waveguide is in the above range, the difference in refractive index from the core of the single-mode quartz optical fiber is reduced, and the interface reflection is suppressed, which also leads to a reduction in connection loss.

Near-Infrared Optical Waveguide and Near-Infrared Optical Transmission Member

In another embodiment of the present invention, there are provided a near-infrared optical waveguide and a near-infrared optical transmission member including at least the near-infrared optical waveguide, the near-infrared optical waveguide containing the cured product of both the aspects described above.

The near-infrared optical waveguide of the present invention includes at least a core and/or a cladding formed from the cured product of both the aspects, and may include a base material. Since the roughness of the end face at the time of cutting is further suppressed, both the core and the cladding are preferably formed from the cured product of both the aspects. The near-infrared optical transmission member of the present embodiment may include, in addition to the near-infrared optical waveguide described above, a connection member, such as a mirror or a connector, to an optical fiber, a silicon photonics optical circuit, or the like.

The cured product of both the aspects described above can be applied to both a cladding forming material for forming a cladding portion of an optical waveguide and a core forming material for forming a core portion. However, the refractive index of the core material forming the core portion needs to be higher than the refractive index of the cladding material forming the cladding portion.

The refractive index of the cured product can be controlled by changing the proportion of a constituent unit of the organopolysiloxane contained in the organopolysiloxane described above or the organopolysiloxane-containing resin composition described above. For example, by increasing the value of M2 + D2 + T2 in Formula [1], i.e., by increasing the content proportion of the polymerizable alkenyl group, the density of the cured product to be produced is increased, and the refractive index can be increased. Conversely, by decreasing the value of M2 + D2 + T2, i.e., by decreasing the content proportion of the polymerizable alkenyl group, the density of the cured product to be produced can be decreased, and the refractive index can be decreased.

In addition, the refractive index of the cured product can be controlled by changing component proportions of the organopolysiloxane-containing resin composition.

In addition, by adjusting the content (vol%) of the polymerizable alkenyl group of the polymerizable alkenyl compound and/or the alkenyl-based polymer contained in the organopolysiloxane-containing resin composition, the crosslinking density of the cured product can be controlled in the same manner as described above, and thus the refractive index can be controlled. In addition, the refractive index can be increased by increasing the aromatic group content (vol%) of the cured product, and the refractive index can be decreased by increasing the fluorine content (vol%). Further, the refractive index of the cured product can be controlled by combining these methods.

In the case of a near-infrared single-mode optical signal, the difference in refractive index between the core material and the cladding material is preferably from 0.01 to 0.05, more preferably from 0.01 to 0.04, and still more preferably from 0.01 to 0.03.

In connection with a near-infrared single-mode quartz-based optical fiber in equipment, a smaller difference in refractive index between the core material of the quartz-based optical fiber and the core material of the optical waveguide may lead to less interface reflection of light at a connection portion and a further reduction in connection loss. In general, the refractive index of the core material of the near-infrared single-mode quartz optical-based fiber at a near-infrared wavelength is from 1.4 to 1.5. When the refractive index of the core material of the optical waveguide is from 1.400 to 1.500 at a wavelength of 589 nm and from 1.400 to 1.500 at a wavelength of 1300 nm, more preferably from 1.430 to 1.490 at a wavelength of 589 nm and from 1.420 to 1.480 at a wavelength of 1300 nm, and still more preferably from 1.435 to 1.480 at a wavelength of 589 nm and from 1.425 to 1.470 at a wavelength of 1300 nm, the difference in refractive index between the two materials is reduced, and the connection loss can be further reduced.

The method for producing the near-infrared optical waveguide of the present embodiment is not particularly limited. For example, the optical waveguide can be formed through a step of curing the organopolysiloxane or the

organopolysiloxane-containing resin composition by exposure (photocuring) or heating (thermal curing).

As a typical example, the optical waveguide can be formed through an etching step and a development step by using a lithography technique using a photomask. In the case of producing the optical waveguide by photolithography, it is preferable to use a composition containing at least an organopolysiloxane and a photopolymerization initiator, and a composition to which a solvent, a chain transfer agent, and the like are further added as necessary can be used. Alternatively, the optical waveguide can be produced by a method such as nanoimprinting.

The optical waveguide forming method by the photolithography method is particularly preferable because an optical waveguide having a small line width and a small pitch can be produced.

As the base material of the near-infrared optical waveguide, a silicon wafer, a silicon wafer with an oxide film, a polyimide resin, an epoxy resin, a PEEK resin, a liquid crystal polymer, glass, a glass epoxy substrate, or the like can be used.

In the case of using the photolithography technique, the core of the optical waveguide can be produced on the base material by an application step of applying the organopolysiloxane-containing resin composition on the base material, an exposure step through a photomask, and a washing step of washing an unexposed composition with a solvent. Further, an over-cladding can be produced by applying the organopolysiloxane or the organopolysiloxane-containing resin composition onto the core produced on the base material and curing the organopolysiloxane or the organopolysiloxane-containing resin composition.

Before the core is produced, an under-cladding may be produced in advance by applying the organopolysiloxane or the organopolysiloxane-containing resin composition onto the base material and curing the organopolysiloxane or the organopolysiloxane-containing resin composition. Alternatively, the waveguide may be peeled off from the base material after the core and the cladding of the optical waveguide are produced on the base material.

In the present embodiment, the transmission loss and connection loss of the optical waveguide can be measured by, for example, methods described in Examples below. The transmission loss is preferably 0.4 dB/cm or less, more preferably 0.35 dB/cm or less, and still more preferably 0.32 dB/cm or less. The connection loss is preferably 1.35 dB or less, more preferably 1.30 dB or less, and still more preferably 1.20 dB/cm or less.

In another embodiment, the present invention provides the following method for producing a near-infrared optical waveguide (may be referred to as the present production method).

A first aspect of the present production method includes:

a step (i-1) of applying a first curable polymer composition to a surface of a substrate to form a first polymer layer;
a step (i-2) of irradiating at least one selected region of the first polymer layer with an active energy ray having a wavelength of from 150 to 800 nm to produce a partially exposed layer having at least one exposed region and at least one unexposed region; and
a step (i-3) of removing the unexposed region of the partially exposed layer with a solvent to form a patterned core, in this order, and
requires that the first curable polymer composition is the organopolysiloxane-containing resin composition or the organopolysiloxane-containing resin composition for a near-infrared optical waveguide.

In the first aspect, the production method preferably further includes:

a step (i-4) of coating the surface of the substrate and the core with a second curable polymer composition to form a second polymer layer; and
a step (i-5) of curing the second polymer layer to form an upper cladding.

The second curable polymer composition is not particularly limited as long as it is a curable composition, but is preferably the organopolysiloxane-containing resin composition.

A second aspect of the present production method includes:

a step (ii-1) of applying a third curable polymer composition to a surface of a substrate to form a third polymer layer;
a step (ii-2) of irradiating at least one selected region of the third polymer layer with an active energy ray having a wavelength of from 150 to 800 nm to produce a partially exposed layer having at least one exposed region and at least one unexposed region;
a step (ii-3) of removing the unexposed region of the partially exposed layer with a solvent to form a patterned core;
a step (ii-4) of coating the surface of the substrate and the core with a fourth curable polymer composition to form a fourth polymer layer; and
a step (ii-5) of curing the fourth polymer layer to form an upper cladding, in this order, and
requires that at least one of the third curable polymer composition or the fourth curable polymer composition is the organopolysiloxane-containing resin composition.

As described above, when at least one of the third curable polymer composition or the fourth curable polymer composition is the organopolysiloxane-containing resin composition, the other curable polymer composition is not particularly limited as long as it is a curable composition. In this aspect, both the third curable polymer and the fourth curable polymer composition are preferably the organopolysiloxane-containing resin composition.

A third aspect of the present production method includes:

a step (iii-1) of applying a fifth curable polymer composition to a surface of a substrate to form a fifth polymer layer;
a step (iii-2) of curing the fifth polymer layer to form a lower cladding;
a step (iii-3) of applying a sixth curable polymer composition onto the lower cladding to form a sixth polymer layer;
a step (iii-4) of irradiating at least one selected region of the sixth polymer layer with an active energy ray having a wavelength of from 150 to 800 nm to produce a partially exposed layer having at least one exposed region and at least one unexposed region; and
a step (iii-5) of removing the unexposed region of the partially exposed layer with a solvent to form a patterned core, in this order, and
requires that at least one of the fifth curable polymer composition or the sixth curable polymer composition is the organopolysiloxane-containing resin composition.

As described above, when at least one of the fifth curable polymer composition or the sixth curable polymer composition is the organopolysiloxane-containing resin composition, the other curable polymer composition is not particularly limited as long as it is a curable composition.

In this aspect, both the fifth curable polymer composition and the sixth curable polymer composition are preferably the organopolysiloxane-containing resin composition.

A fourth aspect of the present production method includes:

a step (iv-1) of applying a fifth curable polymer composition to a surface of a substrate to form a fifth polymer layer;
a step (iv-2) of curing the fifth polymer layer to form a lower cladding;
a step (iv-3) of applying a sixth curable polymer composition onto the lower cladding to form a sixth polymer layer;
a step (iv-4) of irradiating at least one selected region of the sixth polymer layer with an active energy ray having a wavelength of from 150 to 800 nm to produce a partially exposed layer having at least one exposed region and at least one unexposed region;
a step (iv-5) of removing the unexposed region of the partially exposed layer with a solvent to form a patterned core;
a step (iv-6) of coating the lower cladding and the core with a seventh curable polymer composition to form a seventh polymer layer; and
a step (iv-7) of curing the seventh polymer layer to form an upper cladding, in this order, and
requires that at least one of the fifth curable polymer composition, the sixth curable polymer composition, or the seventh curable polymer composition is the organopolysiloxane-containing resin composition.

In this aspect, all of the fifth curable polymer composition, the sixth curable polymer composition, and the seventh curable polymer composition are preferably the organopolysiloxane-containing resin composition.

As the substrate used in the present production method, the base material described above as the base material of the near-infrared optical waveguide can be used. The surface of the substrate to be used is preferably subjected to ozone treatment, plasma treatment, corona treatment, or the like in advance in order to remove deposits on the surface, prevent repelling of the curable polymer composition to be applied, or improve the adhesion. Similarly, before formation of the core and formation of the upper cladding, the surfaces on which the core and the upper cladding are to be formed are preferably subjected to ozone treatment, plasma treatment, corona treatment, or the like in advance.

As described above, in each aspect, the first to seventh curable polymer compositions are required to be at least partially the organopolysiloxane-containing resin composition, but the other curable polymer compositions may be any other polymer compositions that form the core, the lower cladding, or the upper cladding.

Examples of the any other polymer compositions include, but are not limited to, curable silicone compositions other than the organopolysiloxane-containing resin composition; curable polyolefin compositions; curable polyamide compositions; curable epoxy resin compositions; curable amino resin compositions; curable polyurethane compositions; curable polyimide compositions; curable polyester compositions; and curable acrylic resin compositions.

The curable polymer composition can be applied to the substrate using any common method, such as spin coating, die coating, gravure coating, dipping, spraying, brushing, or screen printing. Typically, the curable polymer composition can be applied by spin coating. The spin rotation speed and spin time, as well as the solid content, viscosity, and the like of the curable polymer composition can be adjusted so as to provide a polymer layer with a desired thickness.

When the curable polymer composition contains a solvent, the present production method may further include a step of removing at least a portion of the solvent from the formed polymer layer. The solvent can be removed by heating the

polymer layer at a temperature of from 50°C to 200°C for from several tens of seconds to 60 minutes, or alternatively at a temperature of from 80°C to 150°C for from several tens of seconds to 60 minutes. Alternatively, the solvent may be removed under reduced pressure, or may be removed under reduced pressure and then further removed by heating.

The polymer layer can be cured by various means depending on the curing mechanism of the curable polymer composition. Examples of the means include heating, exposure (active energy rays such as radiation irradiation and ultraviolet irradiation), and exposure to steam. Each condition can be selected as appropriate. For example, the polymer layer can be cured using an exposure device with a high pressure mercury lamp light source. The atmosphere during exposure may be air or an inert atmosphere. When the exposure is performed in an inert atmosphere, an uncured layer formed on a surface of the polymer layer can be reduced.

However, the polymer layer forming the core is irradiated with an active energy ray having a wavelength of from 150 to 800 nm in at least one selected region to produce a partially exposed layer having at least one exposed region and at least one unexposed region. The polymer layer forming the cladding may also be irradiated with an active energy ray having a wavelength of from 150 to 800 nm in at least one selected region to produce a partially exposed layer having at least one exposed region and at least one unexposed region.

After the polymer layer is cured, the cured layer may be further heated and may be exposed again. These treatments may promote curing, and improve the adhesion between the polymer layer and the substrate and the adhesion between the polymer layers. Examples of the conditions for the heating treatment include a temperature of from 50°C to 200°C for from several tens of seconds to 60 minutes, or a temperature of from 80°C to 150°C for from several tens of seconds to 60 minutes.

In the step of forming the core, a so-called development treatment of removing the unexposed region with a solvent is performed, in order to remove the unexposed region, after the curable polymer composition is cured. The solvent used for development and the development method are not limited, and any solvent may be employed as long as the curable polymer composition is dissolved therein, and the curable polymer composition in the unexposed portion is dissolved by any method such as dipping or spraying. Also in the step of forming the cladding, a so-called development treatment of removing the unexposed region with a solvent may be performed, in order to remove the unexposed region, after the curable polymer composition is cured. The solvent used for development and the development method are not limited, and any solvent may be employed as long as the curable polymer composition is dissolved therein, and the curable polymer composition in the unexposed portion is dissolved by any method such as dipping or spraying. In addition, in the step of forming the core and the upper and lower claddings, the same step as the above-described development may be used to remove the uncured layer on the surface of the polymer layer. After the unexposed region is removed with the solvent, the solvent is preferably removed by air drying or heating.

In general, the lower cladding and the upper cladding have a thickness of about from 1 to 100 μm, and the core has a thickness of from 1 to 50 μm. The refractive index of the core is preferably higher than the refractive indices of the claddings, and the size and refractive index of the core allow light to be transmitted in a desired propagation mode.

The present production method can be extended to a high-throughput production method. A plurality of optical waveguides can also be produced simultaneously on a single substrate. Furthermore, the method can use traditional wafer production techniques (e.g., coating, exposure, development, and curing) and devices.

The optical waveguide produced according to the present production method can have excellent micro-processability, heat resistance, low transmission loss at a near-infrared wavelength, and reduced connection loss due to reflection at the optical fiber/optical waveguide interface, as compared with optical waveguides containing other known materials.

## Examples

The present invention will be described in detail below by way of the following Examples, but is not limited by the Examples.

### Evaluation Method

#### (1) $^1$H-NMR Measurement Method

- Device: AVANCE NEO 400 available from Bruker Japan K.K., BBFO Probe (diameter: 5 mm)
- Measurement conditions: pulse repetition time/5 seconds, number of scans/16 times, measuring mode/single pulse, measuring temperature/25°C, flip angle/30°, spin/20 Hz, measuring temperature 25°C
- Preparation of sample: 60 mg of the organopolysiloxane to be measured was weighed, and 12 mg of N,N-dimethylformamide was added as an internal standard. Further, deuterated chloroform was added to dissolve the

organopolysiloxane therein to achieve a total mass of 1 g, and the solution was placed in an NMR sample tube.

- Calculation of functional group content: The functional group content was estimated from the ratio of the signal intensity of each component to the signal intensity of N,N-dimethylformamide as the internal standard, and the weighed value.

(2) $^{29}$Si-NMR Measurement Method

- Preparation of sample: Tris(2,4-pentanedionato)chromium(III) was added to deuterated chloroform to achieve 0.5 mass% to prepare a solvent for $^{29}$Si-NMR measurement. The organopolysiloxane to be measured was weighed in an amount of 1.5 g, and 2.5 ml of the above solvent for $^{29}$Si-NMR measurement was added to dissolve the organopolysiloxane therein, and the solution was placed in an NMR sample tube.

(2)-1: $^{29}$Si-NMR Measurement of Organopolysiloxanes a, c, d, h, and i Described Below

- Device: JNM-ECS400 available from JEOL Ltd., TUNABLE Probe (diameter: 10 mm): Si-free, AT10 probe
- Measurement conditions: pulse repetition time/16 seconds, number of scans/1024 times, measuring mode/non-gated decoupled pulse method (NNE), flip angle/90°, spin/none, measuring temperature/25°C

(2)-2: $^{29}$Si-NMR Measurement of Organopolysiloxanes b and e to g Described Below

- Device: AVANCE NEO 600 available from Bruker Japan K.K., BBO Cryo Probe (diameter: 5 mm)
- Measurement conditions: pulse repetition time/16 seconds, number of scans/1024 times, measuring mode/inverse gate decoupling measurement, flip angle/90°, spin/none, measuring temperature/25°C

Calculation of Constituent Unit

The signal intensity of each unit of silicon was measured, and the constituent proportion of the silicon unit was calculated from the ratio to the signal intensity measured by the above $^{1}$H-NMR and the ratio to the functional group content.

(3) Measurement of Refractive Index of Cured Product

(3)-1: Measurement of Refractive Index at Wavelength of 589 nm

- The refractive indices at a wavelength of 589 nm (visible region) of cured products produced by the method described below were measured using a Kalnew precision refractometer KPR2000 available from Shimadzu Corporation at a temperature of 23°C and using a mixture of diiodomethane, monobromonaphthalene, and liquid paraffin as an intermediate liquid.

(3)-2: Measurement of Refractive Index at Wavelength of 1300 nm

- The refractive indices at a wavelength of 1300 nm (near-infrared light region) of thin film cured products produced on the substrates by the method described below were measured using a Metricon model 2010/M prism coupler (available from PNEUM Co., Ltd.).

(4) Thermal Weight Loss Temperature of Cured Product

The measurement was performed in air at a temperature rising rate of 10°C/min using a thermogravimetry-differential scanning calorimeter (TG-DSC), NEXTA STA200, available from Hitachi High-Technologies Corporation.

(5) Production of Optical Waveguide

An optical waveguide was produced by sequentially forming an under-cladding, a core, and an over-cladding on a silicon substrate by a photolithography method. Detailed procedures will be described below.

(6) Method for Measuring Transmission Loss and Connection Loss of Waveguide

After scratching the silicon substrate side of the waveguide, the waveguide was cut by applying a force by hand to expose an end face, and single mode fibers were connected to both ends. The loss was measured by connecting the incident-side single-mode fiber connected to a temperature-controlled fiber-output high-power LD stabilized light source (LDS1005) available from Precise Gauges Co., Ltd. and the exit-side single-mode fiber connected to a power meter (MT9810B) available from Anritsu Co., Ltd., via a matching oil having a refractive index at a wavelength of 589 nm of 1.51. The loss was measured at two or more points in the waveguide samples having different optical path lengths, and the slope of the approximate straight line of the plot of the loss relative to the optical path length was defined as the transmission loss (dB/cm), and the intercept was defined as the connection loss (dB).

Method for Synthesizing Organopolysiloxane

Synthesis Example 1 Method for Synthesizing Organopolysiloxane a

The organopolysiloxane raw materials used were 210.00 g of 3-methacryloyloxypropyltrimethoxysilane KBM503 available from Shin-Etsu Chemical Co., Ltd. and 101.80 g of dimethyldimethoxysilane KBM22 available from Shin-Etsu Chemical Co., Ltd., the solvents used were 155.90 g of toluene and 155.90 g of methanol, and the catalyst and water used were a mixture of 104.33 g of 1 N hydrochloric acid and 104.33 g of methanol. Hydrolysis condensation was performed while the temperature was maintained within a range of from 15°C to 40°C. The reactant liquid was then neutralized, and washed with demineralized water, followed by removal of the solvents and water and filtration to produce 200 g of a target liquid organopolysiloxane a.

Synthesis Example 2 Method for Synthesizing Organopolysiloxanes b and e

Organopolysiloxanes b and e were produced by synthesis in the same manner as in Synthesis Example 1, except that the amounts of the organopolysiloxane raw materials were changed so as to achieve the proportions of the constituent units shown in Table 1.

Synthesis Example 3 Method for Synthesizing Organopolysiloxane c

With reference to JP 2014-510159 T, an organopolysiloxane c was produced using 3-methacryloyloxypropyltrimethoxysilane KBM503 available from Shin-Etsu Chemical Co., Ltd. and diphenylsilanediol available from Tokyo Chemical Industry Co., Ltd. as organopolysiloxane raw materials.

Synthesis Example 4 Method for Synthesizing Organopolysiloxane d

An organopolysiloxane d was produced in the same manner as in Synthesis Example 3 except that 3-methacryloyloxypropyltrimethoxysilane KBM503 available from Shin-Etsu Chemical Co., Ltd., diphenylsilanediol available from Tokyo Chemical Industry Co., Ltd., and trimethoxy(3,3,3-trifluoropropyl)silane available from Tokyo Chemical Industry Co., Ltd. were used as organopolysiloxane raw materials.

Synthesis Example 5 Method for Synthesizing Organopolysiloxane f

An organopolysiloxane f was produced by synthesis in the same manner as in Synthesis Example 1 using 3-methacryloyloxypropylmethyldimethoxysilane KBM502 available from Shin-Etsu Chemical Co., Ltd. and trimethoxymethylsilane available from Tokyo Chemical Industry Co., Ltd. as organopolysiloxane raw materials.

Synthesis Example 6 Method for Synthesizing Organopolysiloxane g

An organopolysiloxane g was produced by synthesis in the same manner as in Synthesis Example 1 using 3-methacryloyloxypropyltrimethoxysilane KBM503 available from Shin-Etsu Chemical Co., Ltd., dimethyldimethoxysilane KBM22 available from Shin-Etsu Chemical Co., Ltd., and dimethoxy(methyl)(3,3,3-trifluoropropyl)silane available from Tokyo Chemical Industry Co., Ltd. as organopolysiloxane raw materials.

Synthesis Example 7 Method for Synthesizing Organopolysiloxanes h and i

Organopolysiloxanes h and i were produced by synthesis in the same manner as in Synthesis Example 1, except that methyl silicate MS51 available from Mitsubishi Chemical Corporation, 3-methacryloyloxypropyltrimethoxysilane KBM503 available from Shin-Etsu Chemical Co., Ltd., and hexamethyldisiloxane available from Nacalai Tesque, Inc. were used as organopolysiloxane raw materials, and that the amounts of the organopolysiloxane raw materials were changed so as to achieve the proportions of the constituent units shown in Table 1.

Method for Producing Cured Product

To 100 parts by mass of the organopolysiloxane, 2.0 parts by mass (in the case of using the organopolysiloxanes a, b, and e to i) or 0.5 parts by mass (in the case of using the organopolysiloxanes c and d) of 2-benzyl-2-(dimethylamino)-4'-morpholinobutyrophenone (Omnirad 369, available from iGM Resins B. V.) as a photopolymerization initiator was added and stirred to dissolve the photopolymerization initiator, to thereby prepare a composition.

Furthermore, a composition was prepared by adding 2.0 parts by mass of 2-benzyl-2-(dimethylamino)-4'-morpholinobutyrophenone (Omnirad 369) available from iGM Resins B. V. as a photopolymerization initiator and 10 parts by mass of pentaerythritol tetrakis(3-mercaptobutyrate) (PE1, available from Resonac Corporation) as a chain transfer agent to 100 parts by mass of the organopolysiloxane b.

In addition, a composition was prepared by adding 2.0 parts by mass of 2,4,6-trimethylbenzoyldiphenylphosphine oxide (Omnirad TPO H, available from iGM Resins B. V.) instead of Omnirad 369 as a photopolymerization initiator to 100 parts by mass of the organopolysiloxane b, and a composition was prepared by adding 2.0 parts by mass of bis(2,4,6-trimethylbenzoyl)-phenylphosphine oxide (Omnirad 819, available from iGM Resins B. V.) instead of Omnirad 369 as a photopolymerization initiator to 100 parts by mass of the organopolysiloxane b.

Each of the resultant compositions was sandwiched between two glass plates via a silicone spacer having a thickness of 1 mm, and exposed to light from an LED having a wavelength of 365 nm (integrated light quantity: 6000 $mJ/cm^2$) to prepare a test piece having a thickness of about 1 mm.

The refractive index at a wavelength of 589 nm and the 5% weight loss temperature were measured using this test piece.

Method for Producing Thin Film Cured Product on Substrate

To 100 parts by weight of the organopolysiloxane, 2.0 parts by mass (in the case of using the organopolysiloxanes a and b) or 0.5 parts by mass (in the case of using the organopolysiloxanes c and d) of 2-benzyl-2-(dimethylamino)-4'-morpholinobutyrophenone (Omnirad 369, available from iGM Resins B. V.) as a photopolymerization initiator and 60 parts by mass of propylene glycol monomethyl ether acetate as an organic solvent were added, and the mixture was stirred at room temperature.

As a composition containing the organopolysiloxane b, a composition was also prepared by further adding 10 parts by mass of pentaerythritol tetrakis(3-mercaptobutyrate) (PE1, available from Resonac Corporation) as a chain transfer agent.

As the compositions containing the organopolysiloxane b, a composition was prepared by adding 2.0 parts by mass of 2,4,6-trimethylbenzoyldiphenylphosphine oxide (Omnirad TPO H, available from iGM Resins B. V.) instead of Omnirad 369 as a photopolymerization initiator, a composition was prepared by adding 2.0 parts by mass of bis(2,4,6-trimethylbenzoyl)-phenylphosphine oxide (Omnirad 819, available from iGM Resins B. V.) instead of Omnirad 369 as a photopolymerization initiator, and a composition was prepared by adding 2.0 parts by mass of methyl 4-acetoxyimino-5-oxo-5-(4-(phenylthio)phenyl)pentanoate (photopolymerization initiator-1) instead of Omnirad 369 as a photopolymerization initiator.

Each of the resultant compositions was applied onto a glass substrate by spin coating, and then the solvent was removed by a reduced pressure treatment. Thereafter, the composition was photocured (integrated light quantity at 365 nm: 1000 $mJ/cm^2$), and then heated in a heating furnace at 150°C for 3 hours to produce a thin film cured product on the substrate.

Preparation of Composition A Used for Forming Optical Waveguide Core

A container was charged with 100 parts by mass of the organopolysiloxane a, 2 parts by mass of Omnirad 369,

and 20 parts by mass of propylene glycol monomethyl ether acetate, and the mixture was stirred for 2 hours to prepare a composition A to be used for forming an optical waveguide core.

Preparation of Composition H Used for Forming Optical Waveguide Core

A container was charged with 100 parts by mass of the organopolysiloxane h, 2 parts by mass of Omnirad 369, 10 parts by mass of PE1, and 20 parts by mass of propylene glycol monomethyl ether acetate, and the mixture was stirred for 2 hours to prepare a composition H to be used for forming an optical waveguide core.

Preparation of Composition C Used for Forming Optical Waveguide Core

A composition C was prepared in the same manner as in the preparation of the composition A except that the organopolysiloxane c was used instead of the organopolysiloxane a and that the amount of Omnirad 369 was changed to 0.5 parts by mass.

Preparation of Composition B Used for Forming Optical Waveguide Cladding

A composition B was prepared in the same manner as in the preparation of the composition A except that the organopolysiloxane b was used instead of the organopolysiloxane a.

Preparation of Composition D Used for Forming Optical Waveguide Cladding

A composition D was prepared in the same manner as in the preparation of the composition A except that the organopolysiloxane d was used instead of the organopolysiloxane a and that the amount of Omnirad 369 was changed to 0.5 parts by mass.

Preparation of Composition I Used for Forming Optical Waveguide Cladding

A composition I was prepared in the same manner as in the preparation of the composition A except that the organopolysiloxane i was used instead of the organopolysiloxane a.

Example 1

Production of Optical Waveguide

The composition B was applied to an ozone-treated silicon wafer by spin coating, and then subjected to a reduced pressure treatment to remove the solvents, followed by exposure with an exposure device (intensity at a wavelength of 365 nm: 40 mW/cm$^2$, and integrated light quantity: 1000 mJ/cm$^2$). After heating at 130°C for 10 minutes, the insufficiently cured portion of the coating film surface was washed away using propylene glycol monomethyl ether acetate and then using 2-propanol, and heating was performed at 130°C for 30 seconds in a heating furnace, to thereby form an under-cladding having a thickness of about 10 $\mu$m on the silicon wafer substrate. Next, the surface of the silicon wafer substrate on which the lower cladding was produced was subjected to plasma treatment, and then the composition A was applied thereto by spin coating. The solvents were then removed by a reduced pressure treatment, followed by mask exposure with an exposure device (intensity at a wavelength of 365 nm: 500 mW/cm$^2$, and integrated light quantity: 2000 mJ/cm$^2$). After heating at 130°C for 10 minutes, the composition of the unexposed portion was washed away using propylene glycol monomethyl ether acetate and then using 2-propanol, and heating was performed at 130°C for 30 seconds in a heating furnace, to thereby form a core on the lower cladding on the silicon wafer substrate. Subsequently, the surfaces of the silicon wafer substrate on which the under-cladding and the core were produced were subjected to plasma treatment, and the composition B was applied by spin coating. Then, the solvents were removed by a reduced pressure treatment, followed by exposure with an exposure device (intensity at a wavelength of 365 nm: 40 mW/cm$^2$, and integrated light quantity: 1000 mJ/cm$^2$). After heating at 130°C for 10 minutes, the insufficiently cured portion of the coating film surface was washed away using propylene glycol monomethyl ether acetate and then using 2-propanol, and heating was performed in a heating furnace at 130°C for 30 seconds, and further heating was performed in the heating furnace at 150°C for 1 hour to form an over-cladding on the lower cladding and the core on the silicon wafer substrate, to thereby produce an optical waveguide X.

Comparative Examples 1 and 2

In the same manner as in the above Examples, a waveguide Y of Comparative Example 2 was produced using the composition C for core formation and the composition D for cladding formation, and a waveguide Z of Comparative Example 1 was produced using the composition H for core formation and the composition I for cladding formation.

Evaluation of Molecular Constituent Proportion of Organopolysiloxane, Cured Product, and Optical Waveguide

The molecular constituent proportion of the organopolysiloxane before curing calculated by $^{1}$H-NMR and $^{29}$Si-NMR measurements and the evaluation results of the cured product are shown in Table 1. Table 2 shows evaluation results of the optical waveguides of the Examples and the Comparative Examples.

[Table 1]

Table 1

| Organopolysiloxane | Photopolymerization initiator | Additional additive*1 | Coefficients in Formula [1] | | | | | | | | | Proportion (mol%) of aromatic group in R1 to R1 1 | Evaluation results of cured product | | |
|---|---|---|---|---|---|---|---|---|---|---|---|---|---|---|---|
| | | | M1 | M2 | D1 | D2 | T1 | T2 | Q | Y1 | Y2 | | 5% weight loss temperature (°C) | Refractive Index | |
| | | | | | | | | | | | | | | 589 nm | 1300 nm |
| a | Omnirad 369 | - | 0 | 0 | 0.501 | 0 | 0 | 0.499 | 0 | 0.134 | 0 | 0 | 359 | 1.476 | 1.463 |
| b | Omnirad 369 | - | 0 | 0 | 0.653 | 0 | 0 | 0.347 | 0 | 0.092 | 0 | 0 | 328 | 1.465 | 1.456 |
| e | Omnirad 369 | - | 0 | 0 | 0.306 | 0 | 0 | 0.694 | 0 | 0.259 | 0 | 0 | 369 | - | 1.477 |
| f | Omnirad 369 | - | 0 | 0 | 0 | 0.204 | 0.796 | 0 | 0 | 0.101 | 0 | 0 | - | - | 1.440 |
| g | Omnirad 369 | - | 0 | 0 | 0.637 | 0 | 0 | 0.363 | 0 | 0.122 | 0 | 0 | - | - | 1.441 |
| b | Omnirad 369 | PE1 | 0 | 0 | 0.653 | 0 | 0 | 0.347 | 0 | 0.092 | 0 | 0 | 356 | - | 1.461 |
| b | Omnirad TPO H | - | 0 | 0 | 0.653 | 0 | 0 | 0.347 | 0 | 0.092 | 0 | 0 | 321 | - | 1.440 |
| b | Omnirad 819 | - | 0 | 0 | 0.653 | 0 | 0 | 0.347 | 0 | 0.092 | 0 | 0 | 314 | - | 1.439 |
| b | Photopolymerization initiator-1 | - | 0 | 0 | 0.653 | 0 | 0 | 0.347 | 0 | 0.092 | 0 | 0 | - | - | 1.439 |
| h | Omnirad 369 | - | 0.388 | 0 | 0 | 0 | 0 | 0.309 | 0.303 | 0.131 | 0 | 0 | 356 | 1.462 | 1.453 |
| i | Omnirad 369 | - | 0.384 | 0 | 0 | 0 | 0 | 0.209 | 0.407 | 0.096 | 0 | 0 | 360 | 1.452 | 1.439 |
| c | Omnirad 369 | - | 0 | 0 | 0.530 | 0 | 0 | 0.470 | 0 | 0.487 | 0 | 70.2 | 352 | 1.558 | 1.538 |
| d | Omnirad 369 | - | 0 | 0 | 0.545 | 0 | 0.233 | 0.222 | 0 | 0.487 | 0 | 70.6 | 340 | 1.538 | 1.511 |

*1: Additional additives are additives other than the photopolymerization initiator and the solvent.

[Table 2]

Table 2

| | Waveguide | Composition used for formation of core | Composition used for formation of cladding | Transmission loss (dB/cm) | Connection loss (dB) |
|---|---|---|---|---|---|
| Example 1 | X | A | B | 0.31 | 1.17 |
| Comparative Example 1 | Z | H | I | 0.38 | 1.58 |
| Comparative Example 2 | Y | C | D | 0.40 | 1.37 |

Example 2

Method 1 for Producing Optical Waveguide Having Core on Substrate

To 100 parts by mass of the organopolysiloxane a, 2.0 parts by mass of 2-benzyl-2-(dimethylamino)-4'-morpholinobutyrophenone (Omnirad 369, available from iGM Resins B. V.) as a photopolymerization initiator and 20 parts by mass of propylene glycol monomethyl ether acetate as an organic solvent were added, and the mixture was stirred at room temperature. This composition was designated as a first curable polymer composition. The first curable polymer composition was applied by spin coating onto a silicon wafer substrate whose surface had been treated with ozone, and then the solvents were removed by a reduced pressure treatment, followed by mask exposure with an exposure device (intensity at a wavelength of 365 nm: 500 mW/$cm^2$, integrated light quantity: 2000 mJ/$cm^2$). After heating at 130°C for 10 minutes, the composition of the unexposed portion was washed away using propylene glycol monomethyl ether acetate and then using 2-propanol, heating was performed at 130°C for 30 seconds in a heating furnace, and further heating was performed at 150°C for 1 hour in the heating furnace, to thereby form a core of an optical waveguide on the silicon wafer substrate.
FIG. 1 is a schematic cross-sectional view of the optical waveguide produced in Example 2.

Example 3

Method 2 for Producing Optical Waveguide Having Core/Upper Cladding on Substrate

To 100 parts by mass of the organopolysiloxane b, 2.0 parts by mass of 2-benzyl-2-(dimethylamino)-4'-morpholinobutyrophenone (Omnirad 369, available from iGM Resins B. V.) as a photopolymerization initiator and 20 parts by mass of propylene glycol monomethyl ether acetate as an organic solvent were added, and the mixture was stirred at room temperature. This composition was designated as a second curable polymer composition. The surface of the silicon wafer substrate on which the core of the optical waveguide was produced in Example 2 was subjected to plasma treatment, and the second curable polymer composition was applied by spin coating. Then, the solvent was removed by a reduced pressure treatment, followed by exposure with an exposure device (intensity at a wavelength of 365 nm: 40 mW/$cm^2$, and integrated light quantity: 1000 mJ/$cm^2$). After heating at 130°C for 10 minutes, the insufficiently cured portion of the coating film surface was washed away using propylene glycol monomethyl ether acetate and then using 2-propanol, and heating was performed in a heating furnace at 130°C for 30 seconds, and further heating was performed in the heating furnace at 150°C for 1 hour, to thereby produce an optical waveguide having a core and an upper cladding on the silicon wafer substrate.
FIG. 2 is a schematic cross-sectional view of the optical waveguide produced in Example 3.

Example 4

Method 3 for Producing Optical Waveguide Having Core/Lower Cladding on Substrate

To 100 parts by mass of the organopolysiloxane b, 2.0 parts by mass of 2-benzyl-2-(dimethylamino)-4'-morpholinobutyrophenone (Omnirad 369, available from iGM Resins B. V.) as a photopolymerization initiator and 20 parts by mass of propylene glycol monomethyl ether acetate as an organic solvent were added, and the mixture was stirred at room temperature. This composition was designated as a fifth curable polymer composition. The fifth curable polymer

composition was applied by spin coating onto a silicon wafer substrate whose surface had been treated with ozone, and then the solvent was removed by a reduced pressure treatment, followed by exposure with an exposure device (intensity at a wavelength of 365 nm: 40 mW/cm$^2$, integrated light quantity: 1000 mJ/cm$^2$). After heating at 130°C for 10 minutes, the insufficiently cured portion of the coating film surface was washed away using propylene glycol monomethyl ether acetate and then using 2-propanol, and heating was performed at 130°C for 30 seconds in a heating furnace to produce a lower cladding formed of the fifth curable polymer composition on the silicon wafer substrate.

To 100 parts by mass of the organopolysiloxane a, 2.0 parts by mass of 2-benzyl-2-(dimethylamino)-4'-morpholinobutyrophenone (Omnirad 369, available from iGM Resins B. V.) as a photopolymerization initiator and 20 parts by mass of propylene glycol monomethyl ether acetate as an organic solvent were added, and the mixture was stirred at room temperature. This composition was designated as a sixth curable polymer composition. The surface of the silicon wafer substrate on which the lower cladding was produced was subjected to plasma treatment, and the sixth curable polymer composition was applied by spin coating. The solvent was then removed by a reduced pressure treatment, followed by mask exposure with an exposure device (intensity at a wavelength of 365 nm: 500 mW/cm$^2$, and integrated light quantity: 2000 mJ/cm$^2$). After heating at 130°C for 10 minutes, the composition of the unexposed portion was washed away using propylene glycol monomethyl ether acetate and then using 2-propanol, and heating was performed in a heating furnace at 130°C for 30 seconds, and further heating was performed in the heating furnace at 150°C for 1 hour, to thereby produce an optical waveguide having a lower cladding formed of the fifth curable polymer composition and a core formed of the sixth curable polymer composition on the silicon wafer substrate.

FIG. 3 is a schematic cross-sectional view of the optical waveguide produced in Example 4.

Example 5

Method 4 for Producing Optical Waveguide Having Lower Cladding/Core/Upper Cladding on Substrate

To 100 parts by mass of the organopolysiloxane b, 2.0 parts by mass of 2-benzyl-2-(dimethylamino)-4'-morpholinobutyrophenone (Omnirad 369, available from iGM Resins B. V.) as a photopolymerization initiator and 20 parts by mass of propylene glycol monomethyl ether acetate as an organic solvent were added, and the mixture was stirred at room temperature. This composition was designated as a seventh curable polymer composition. The surfaces of the silicon wafer substrate on which the lower cladding and the core were produced in Example 4 were subjected to plasma treatment, and the seventh curable polymer composition was applied by spin coating. Then, the solvent was removed by a reduced pressure treatment, followed by exposure with an exposure device (intensity at a wavelength of 365 nm: 40 mW/cm$^2$, and integrated light quantity: 1000 mJ/cm$^2$). After heating at 130°C for 10 minutes, the insufficiently cured portion of the coating film surface was washed away using propylene glycol monomethyl ether acetate and then using 2-propanol, and heating was performed in a heating furnace at 130°C for 30 seconds, and further heating was performed in the heating furnace at 150°C for 1 hour, to thereby produce an optical waveguide having a lower cladding formed of the fifth curable polymer composition, a core formed of the sixth curable polymer composition, and an upper cladding formed of the seventh curable polymer composition on the silicon wafer substrate.

FIG. 4 is a schematic cross-sectional view of the optical waveguide produced in Example 5.

As shown in Tables 1 and 2, the waveguides X produced using the organopolysiloxanes a and b, which have an organic group containing a polymerizable alkenyl group and a siloxane unit (D unit) represented by $SiO_{2/2}$ and in which the proportion of the aromatic group in the total of all the groups bonded to the silicon atoms is 20 mol% or less, have refractive indices of the core portions of 1.476 and 1.463 at wavelengths of 589 nm and 1300 nm, respectively. It can be seen that, when the waveguides X are connected to a single-mode quartz optical fiber, the difference in refractive index between the core portions is small, and interface reflection is suppressed. As a result of the measurement, the transmission loss was 0.4 dB/cm or less, and the connection loss was also a low loss of 1.20 dB or less.

The waveguides Y produced using the organopolysiloxanes c and d, which have an organic group containing a polymerizable alkenyl group and a siloxane unit (D unit) represented by $SiO_{2/2}$ but in which the proportion of the aromatic group in the total of all the groups bonded to the silicon atoms is more than 20 mol%, have refractive indices of the core portions of 1.558 and 1.538 at wavelengths of 589 nm and 1300 nm, respectively. When the waveguides Y are connected to a single-mode quartz optical fiber, the difference in refractive index between the core portions is large, and interface reflection is not suppressed. As a result of the measurement, the transmission loss was 0.4 dB/cm or less, but the connection loss was 1.30 dB or more.

In the waveguides Z produced using the organopolysiloxanes h and i having an organic group containing a polymerizable alkenyl group and having a proportion of the aromatic group of 20 mol% or less but having no siloxane unit (D unit) represented by $SiO_{2/2}$, the transmission loss and the connection loss increased. The results indicated that the D unit is necessary in order to reduce the transmission loss and the connection loss.

The difference between the refractive index of the cured product of the organopolysiloxane of the present embodiment and the refractive index of the quartz optical fiber core is small, and by using the cured product as a core

material of a near-infrared optical waveguide, interface reflection is suppressed when the cured product is connected to a near-infrared single-mode quartz-based optical fiber. In the case of a near-infrared optical waveguide using the core material, the cured product of the organopolysiloxane of the present embodiment is useful also as a cladding material of the near-infrared optical waveguide because the difference in refractive index between the core portion and the cladding portion is small.

Furthermore, the cured product of the organopolysiloxane of the present embodiment has toughness, and an optical waveguide formed of the cured product is less likely to crack at an end face at the time of cutting, and has a small connection loss. Therefore, the organopolysiloxane of the present embodiment is useful as a material for forming a near-infrared optical waveguide. It was also confirmed that the addition of a chain transfer agent improves the curability and improves the heat resistance of the cured product.

In addition, from the viewpoint of optical characteristics, heat resistance, and patterning properties by lithography, the organopolysiloxane can be expected to be used as an optical waveguide to be connected to a non-quartz-based optical fiber having a refractive index of the core material of about from 1.4 to 1.5, or an optical adhesive used for a connection portion between an optical waveguide and an optical fiber.

Reference Signs List

10 Substrate
20 Lower cladding layer
30 Upper cladding layer
40 Core

## Claims

1. An organopolysiloxane represented by General Formula [1] described below:

$$(R^1R^2R^3SiO_{1/2})_{M1}(R^4R^5R^6SiO_{1/2})_{M2}$$

$$(R^7R^8SiO_{2/2})_{+}(R^9R^6SiO_{2/2})_{D2}$$

$$(R^{10}SiO_{3/2})_{T1}(R^6SiO_{3/2})_{T2}(SiO_{4/2})_{Q}$$

$$(O_{1/2}R^{11})_{Y1}(O_{1/2}R^6)_{Y2} \cdots \qquad [1]$$

[in Formula [1], $R^1$ to $R^5$ and $R^7$ to $R^{11}$ are each independently one or two or more groups selected from an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or two or more organic groups containing a polymerizable alkenyl group, which are optionally the same or different;
$0 \leq M1$, $0 \leq Q$, $0 \leq Y1$, and $0 \leq Y2$;

$$0 < D1 + D2,$$

$$0 < M2 + D2 + T2,$$

and

$$M1 + M2 + D1 + D2 + T1 + T2 + Q = 1;$$

and
a proportion of an aromatic group in a total of all groups bonded to silicon atoms is 20 mol% or less].

2. The organopolysiloxane according to claim 1, wherein $0.1 < D1 + D2$ in Formula [1].

3. The organopolysiloxane according to claim 1, wherein $0 < D1$ in Formula [1].

4. The organopolysiloxane according to claim 1, wherein $0.02 \leq Y1 \leq 0.25$ in Formula [1].

5. The organopolysiloxane according to claim 1, wherein, in Formula [1], $R^7$ to $R^9$ do not contain an aromatic group.

6. The organopolysiloxane according to claim 1, wherein, in Formula [1], $R^1$ to $R^{11}$ do not contain an aromatic group.

7. The organopolysiloxane according to claim 1, wherein, in Formula [1], $R^6$ has one or more functional groups selected from the group represented by Formulae [2] to [5] described below in one molecule:

[Chem. 1]

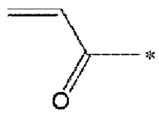
[2]

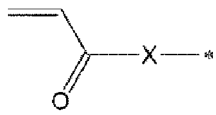
[3]

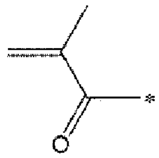
[4]

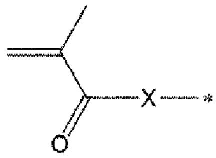
[5]

(in Formulae described above, X is a divalent organic group, and optionally contains a branched structure and/or a cyclic structure; when X is bonded to a silicon atom, an atom which is at a terminal of X and is directly bonded to silicon is a carbon atom; when X is bonded to an oxygen atom directly bonded to silicon, an atom which is at a terminal of X and is directly bonded to the oxygen atom is a carbon atom; and * represents a bond).

8. The organopolysiloxane according to claim 1, wherein, in Formula [1], $R^6$ is an acryloyloxypropyl group and/or a methacryloyloxypropyl group.

9. The organopolysiloxane according to claim 1, wherein, in General Formula [1], $R^7$ and $R^8$ are each independently an alkyl group having from 1 to 20 carbons.

10. An organopolysiloxane-containing resin composition comprising the organopolysiloxane described in any one of claims 1 to 9 and a polymerization initiator.

11. A cured product produced by curing the organosiloxane-containing resin composition described in claim 10.

12. A near-infrared optical waveguide produced using the organosiloxane-containing resin composition described in claim 10.

13. A near-infrared optical waveguide comprising a core portion and a cladding portion, wherein both the core portion and the cladding portion are produced using the organosiloxane-containing resin composition described in claim 10.

14. A near-infrared optical transmission member comprising at least the near-infrared optical waveguide described in claim 12.

15. A near-infrared optical transmission member comprising at least the near-infrared optical waveguide described in claim 13.

16. A method for producing a near-infrared optical waveguide, the method comprising:

(i-1) applying a first curable polymer composition to a surface of a substrate to form a first polymer layer;
(i-2) irradiating at least one selected region of the first polymer layer with an active energy ray having a wavelength

of from 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane-containing resin composition described in claim 10.

**17.** The method for producing a near-infrared optical waveguide according to claim 16, further comprising:

(i-4) coating the surface of the substrate and the core with a second curable polymer composition to form a second polymer layer; and
(i-5) curing the second polymer layer to form an upper cladding.

**18.** The method for producing a near-infrared optical waveguide according to claim 17, wherein the second curable polymer composition is the organopolysiloxane-containing resin composition described in claim 10.

**19.** A method for producing a near-infrared optical waveguide, the method comprising:

(ii-1) applying a third curable polymer composition to a surface of a substrate to form a third polymer layer;
(ii-2) irradiating at least one selected region of the third polymer layer with an active energy ray having a wavelength of from 150 to 800 nm to produce a partially exposed layer having at least one exposed region and at least one unexposed region;
(ii-3) removing the unexposed region of the partially exposed layer with a solvent to form a patterned core;
(ii-4) coating the surface of the substrate and the core with a fourth curable polymer composition to form a fourth polymer layer; and
(ii-5) curing the fourth polymer layer to form an upper cladding, in this order, wherein

at least one of the third curable polymer composition or the fourth curable polymer composition is the organopolysiloxane-containing resin composition described in claim 10.

**20.** The method for producing a near-infrared optical waveguide according to claim 19, wherein both the third curable polymer composition and the fourth curable polymer composition are the organopolysiloxane-containing resin composition described in claim 10.

**21.** A method for producing a near-infrared optical waveguide, the method comprising:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of from 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the organopolysiloxane-containing resin composition described in claim 10.

**22.** The method for producing a near-infrared optical waveguide according to claim 21, wherein both the fifth curable polymer composition and the sixth curable polymer composition are the organopolysiloxane-containing resin composition described in claim 10.

**23.** A method for producing a near-infrared optical waveguide, the method comprising:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a

wavelength of from 150 to 800 nm to produce a partially exposed layer having at least one exposed region and at least one unexposed region;
(iv-5) removing the unexposed region of the partially exposed layer with a solvent to form a patterned core;
(iv-6) coating the lower cladding and the core with a seventh curable polymer composition to form a seventh polymer layer; and
(iv-7) curing the seventh polymer layer to form an upper cladding, in this order, wherein

at least one of the fifth curable polymer composition, the sixth curable polymer composition, or the seventh curable polymer composition is the organopolysiloxane-containing resin composition described in claim 10.

**24.** The method for producing a near-infrared optical waveguide according to claim 23, wherein all the fifth curable polymer composition, the sixth curable polymer composition, and the seventh curable polymer composition are the organopolysiloxane-containing resin composition described in claim 10.

**25.** A cured product comprising a crosslinked structure derived from an organic group containing a polymerizable alkenyl group; and a siloxane unit (D unit) represented by $SiO_{2/2}$, wherein the cured product has a refractive index of 1.400 or more and 1.500 or less at a wavelength of 1300 nm.

**26.** The cured product according to claim 25, wherein the cured product has a refractive index of 1.400 or more and 1.500 or less at a wavelength of 589 nm.

**27.** The cured product according to claim 25, wherein the cured product is produced by curing an organopolysiloxane represented by General Formula [1] described below:

$$(R^1R^2R^3SiO_{1/2})_{M1}(R^4R^5R^6SiO_{1/2})_{M2}$$

$$(R^7R^8SiO_{2/2})_{D1}(R^9R^6SiO_{2/2})_{D2}$$

$$(R^{10}SiO_{3/2})_{T1}(R^6SiO_{3/2})_{T2}(SiO_{4/2})_{Q}$$

$$(O_{1/2}R^{11})_{Y1}(O_{1/2}R^6)_{Y2} \cdots \quad [1]$$

[in Formula [1], $R^1$ to $R^5$ and $R^7$ to $R^{11}$ are each independently one or two or more groups selected from an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or two or more organic groups containing a polymerizable alkenyl group, which are optionally the same or different;
$0 \leq M1$, $0 \leq Q$, $0 \leq Y1$, and $0 \leq Y2$;

$$0 < D1 + D2,$$

$$0 < M2 + D2 + T2,$$

and

$$M1 + M2 + D1 + D2 + T1 + T2 + Q = 1;$$

and
a proportion of an aromatic group in a total of all groups bonded to silicon atoms is 20 mol% or less].

**28.** The cured product according to claim 27, wherein $0.1 < D1 + D2$ in Formula [1].

**29.** The cured product according to claim 27, wherein $0 < D1$ in Formula [1].

**30.** The cured product according to claim 27, wherein $0.02 \leq Y1 \leq 0.25$ in Formula [1].

**31.** The cured product according to claim 27, wherein, in Formula [1], $R^1$ to $R^{11}$ do not contain an aromatic group.

**32.** The cured product according to claim 27, wherein, in Formula [1], $R^6$ has one or more functional groups selected from the group represented by Formulae [2] to [5] described below in one molecule:

[Chem. 2]

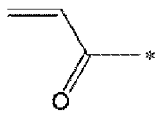
[2]

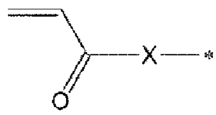
[3]

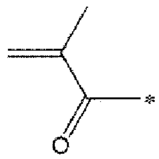
[4]

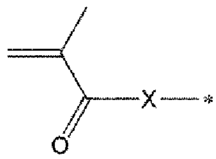
[5]

(in Formulae described above, X is a divalent organic group, and optionally contains a branched structure and/or a cyclic structure; when X is bonded to a silicon atom, an atom which is at a terminal of X and is directly bonded to silicon is a carbon atom; when X is bonded to an oxygen atom directly bonded to silicon, an atom which is at a terminal of X and is directly bonded to the oxygen atom is a carbon atom; and * represents a bond).

**33.** The cured product according to claim 27, wherein, in Formula [1], $R^6$ is an acryloyloxypropyl group and/or a methacryloyloxypropyl group.

**34.** The cured product according to claim 27, wherein, in General Formula [1], $R^7$ and $R^8$ are each independently an alkyl group having from 1 to 20 carbons.

**35.** A near-infrared optical waveguide comprising the cured product described in any one of claims 25 to 34.

**36.** A near-infrared waveguide comprising a core portion and a cladding portion, wherein both the core portion and the cladding portion contain the cured product described in any one of claims 25 to 34.

**37.** A near-infrared optical transmission member comprising at least the near-infrared optical waveguide described in claim 35.

**38.** A near-infrared optical transmission member comprising at least the near-infrared optical waveguide described in claim 36.

**39.** An organopolysiloxane for a near-infrared optical waveguide, the organopolysiloxane comprising:

an organic group containing a polymerizable alkenyl group; and
a siloxane unit (D unit) represented by $SiO_{2/2}$, wherein
a proportion of an aromatic group is 20 mol% or less in a total of all groups bonded to silicon atoms.

**40.** The organopolysiloxane for a near-infrared optical waveguide according to claim 39, wherein the organopolysiloxane is represented by General Formula [1] described below:

$$(R^1R^2R^3SiO_{1/2})_{M1}(R^4R^5R^6SiO_{1/2})_{M2}$$

$$(R^7R^8SiO_{2/2})_{D1}(R^9R^6SiO_{2/2})_{D2}$$

$$(R^{10}SiO_{3/2})_{T1}(R^6SiO_{3/2})_{T2}(SiO_{4/2})_Q$$

$$(O_{1/2}R^{11})_{Y1}(O_{1/2}R^6)_{Y2} \cdots \quad [1]$$

[in Formula [1], $R^1$ to $R^5$ and $R^7$ to $R^{11}$ are each independently one or more groups selected from the group consisting of an organic group, a reactive functional group, and a hydrogen atom;
$R^1$ to $R^3$, $R^7$, $R^8$, $R^{10}$, and $R^{11}$ do not contain a polymerizable alkenyl group;
$R^6$ is one or more organic groups containing a polymerizable alkenyl group, and when a plurality of $R^6$s are present, they are optionally the same or different;
a proportion of an aromatic group in a total of $R^1$ to $R^{11}$ is 20 mol% or less;
$0 \leq M1$, $0 \leq Q$, $0 \leq Y1$, and $0 \leq Y2$;

$$0 < D1 + D2, \text{ and } 0 < M2 + D2 + T2;$$

and

$$M1 + M2 + D1 + D2 + T1 + T2 + Q = 1].$$

**41.** The organopolysiloxane for a near-infrared optical waveguide according to claim 40, wherein $0.1 < D1 + D2$ in Formula [1].

**42.** The organopolysiloxane for a near-infrared optical waveguide according to claim 40, wherein $0 < D1$ in Formula [1].

**43.** The organopolysiloxane for a near-infrared optical waveguide according to claim 40, wherein $0.02 \leq Y1 \leq 0.25$ in Formula [1].

**44.** The organopolysiloxane for a near-infrared optical waveguide according to claim 40, wherein, in Formula [1], $R^7$ to $R^9$ do not contain an aromatic group.

**45.** The organopolysiloxane for a near-infrared optical waveguide according to claim 40, wherein, in Formula [1], $R^6$ has one or more functional groups selected from the group represented by Formulae [2] to [5] described below in one molecule:

[Chem. 3]

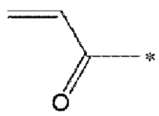 [2] 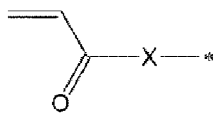 [3]

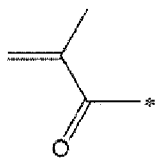 [4] 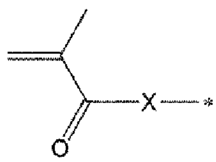 [5]

(in Formulae described above, X is a divalent organic group, and optionally contains a branched structure and/or a cyclic structure; when X is bonded to a silicon atom, an atom which is at a terminal of X and is directly bonded to silicon is a carbon atom; when X is bonded to an oxygen atom directly bonded to silicon, an atom which is at a terminal of X and is directly bonded to the oxygen atom is a carbon atom; and * represents a bond).

**46.** The organopolysiloxane for a near-infrared optical waveguide according to claim 40, wherein, in Formula [1], $R^6$ is an acryloyloxypropyl group and/or a methacryloyloxypropyl group.

**47.** The organopolysiloxane for a near-infrared optical waveguide according to claim 40, wherein, in Formula [1], $R^1$ to $R^{11}$ do not contain an aromatic group.

**48.** An organopolysiloxane-containing resin composition for a near-infrared optical waveguide, the resin composition comprising the organopolysiloxane for a near-infrared optical waveguide described in claim 39 or 40 and a polymerization initiator.

**49.** A cured product for a near-infrared optical waveguide, the cured product being produced by curing the organopolysiloxane-containing resin composition for a near-infrared optical waveguide described in claim 48.

**50.** A near-infrared optical waveguide produced using the organopolysiloxane-containing resin composition for a near-infrared optical waveguide described in claim 48.

**51.** A near-infrared waveguide comprising a core portion and a cladding portion, wherein both the core portion and the cladding portion are produced using the organopolysiloxane-containing resin composition for a near-infrared optical waveguide described in claim 48.

**52.** A near-infrared optical transmission member comprising at least the near-infrared optical waveguide described in claim 50.

**53.** A near-infrared optical transmission member comprising at least the near-infrared optical waveguide described in claim 51.

**54.** A method for producing a near-infrared optical waveguide, the method comprising:

(i-1) applying a first curable polymer composition to a surface of a substrate to form a first polymer layer;
(i-2) irradiating at least one selected region of the first polymer layer with an active energy ray having a wavelength of from 150 to 800 nm to produce a partially exposed layer having at least one exposed region and at least one unexposed region; and
(i-3) removing the unexposed region of the partially exposed layer with a solvent to form a patterned core, in this order, wherein

the first curable polymer composition is the organopolysiloxane-containing resin composition for a near-infrared optical waveguide described in claim 48.

**55.** The method for producing a near-infrared optical waveguide according to claim 54, further comprising:

(i-4) coating the surface of the substrate and the core with a second curable polymer composition to form a second polymer layer; and
(i-5) curing the second polymer layer to form an upper cladding.

**56.** The method for producing a near-infrared optical waveguide according to claim 55, wherein the second curable polymer composition is the organopolysiloxane-containing resin composition for a near-infrared optical waveguide described in claim 48.

**57.** A method for producing a near-infrared optical waveguide, the method comprising:

(ii-1) applying a third curable polymer composition to a surface of a substrate to form a third polymer layer;
(ii-2) irradiating at least one selected region of the third polymer layer with an active energy ray having a wavelength of from 150 to 800 nm to produce a partially exposed layer having at least one exposed region and at least one unexposed region;
(ii-3) removing the unexposed region of the partially exposed layer with a solvent to form a patterned core;
(ii-4) coating the surface of the substrate and the core with a fourth curable polymer composition to form a fourth polymer layer; and
(ii-5) curing the fourth polymer layer to form an upper cladding, in this order, wherein

at least one of the third curable polymer composition or the fourth curable polymer composition is the organopolysiloxane-containing resin composition for a near-infrared optical waveguide described in claim 48.

**58.** The method for producing a near-infrared optical waveguide according to claim 57, wherein both the third curable polymer composition and the fourth curable polymer composition are the organopolysiloxane-containing resin composition for a near-infrared optical waveguide described in claim 48.

**59.** A method for producing a near-infrared optical waveguide, the method comprising:

(iii-1) applying a fifth curable polymer composition to a surface of a substrate to form a fifth polymer layer;
(iii-2) curing the fifth polymer layer to form a lower cladding;
(iii-3) applying a sixth curable polymer composition onto the lower cladding to form a sixth polymer layer;
(iii-4) irradiating at least one selected region of the sixth polymer layer with an active energy ray having a wavelength of from 150 to 800 nm to produce a partially exposed layer having at least one exposed region and at least one unexposed region; and
(iii-5) removing the unexposed region of the partially exposed layer with a solvent to form a patterned core, in this order, wherein

at least one of the fifth curable polymer composition or the sixth curable polymer composition is the organopolysiloxane-containing resin composition for a near-infrared optical waveguide described in claim 48.

**60.** The method for producing a near-infrared optical waveguide according to claim 59, wherein both the fifth curable polymer composition and the sixth curable polymer composition are the organopolysiloxane-containing resin composition for a near-infrared optical waveguide described in claim 48.

**61.** A method for producing a near-infrared optical waveguide, the method comprising:

(iv-1) applying a fifth curable polymer composition to a surface of a substrate to form a fifth polymer layer;
(iv-2) curing the fifth polymer layer to form a lower cladding;
(iv-3) applying a sixth curable polymer composition onto the lower cladding to form a sixth polymer layer;
(iv-4) irradiating at least one selected region of the sixth polymer layer with an active energy ray having a wavelength of from 150 to 800 nm to produce a partially exposed layer having at least one exposed region and at least one unexposed region;
(iv-5) removing the unexposed region of the partially exposed layer with a solvent to form a patterned core;
(iv-6) coating the lower cladding and the core with a seventh curable polymer composition to form a seventh polymer layer; and
(iv-7) curing the seventh polymer layer to form an upper cladding, in this order, wherein

at least one of the fifth curable polymer composition, the sixth curable polymer composition, or the seventh curable polymer composition is the organopolysiloxane-containing resin composition for a near-infrared optical waveguide described in claim 48.

**62.** The method for producing a near-infrared optical waveguide according to claim 61, wherein all the fifth curable polymer composition, the sixth curable polymer composition, and the seventh curable polymer composition are the organopolysiloxane-containing resin composition for a near-infrared optical waveguide described in claim 48.

Fig 1

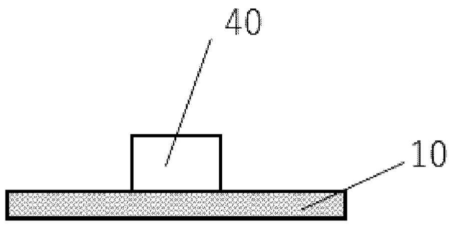


Fig 2

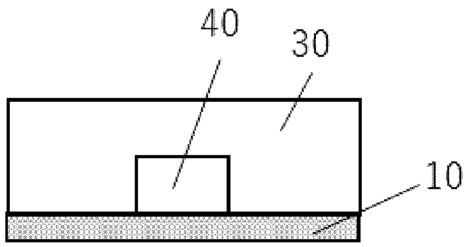


Fig 3

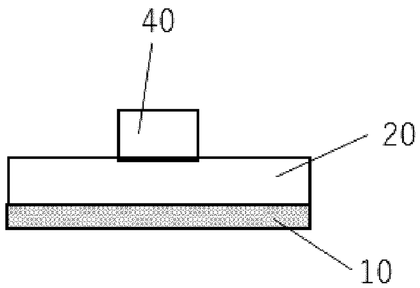


Fig 4

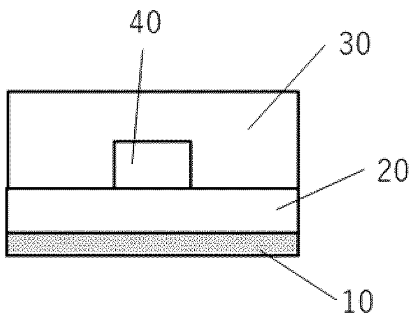

# INTERNATIONAL SEARCH REPORT

International application No.
**PCT/JP2024/032123**

## A. CLASSIFICATION OF SUBJECT MATTER

***C08G 77/20***(2006.01)i; ***C08F 299/08***(2006.01)i; ***G02B 6/12***(2006.01)i
FI: C08G77/20; C08F299/08; G02B6/12 371

According to International Patent Classification (IPC) or to both national classification and IPC

## B. FIELDS SEARCHED

Minimum documentation searched (classification system followed by classification symbols)

C08G77/20; C08F299/08; G02B6/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

## C. DOCUMENTS CONSIDERED TO BE RELEVANT

| Category* | Citation of document, with indication, where appropriate, of the relevant passages | Relevant to claim No. |
|---|---|---|
| X | WO 2015/037571 A1 (TOAGOSEI CO., LTD.) 19 March 2015 (2015-03-19) claims, examples | 1-62 |
| X | JP 2010-006939 A (SEKISUI CHEMICAL CO., LTD.) 14 January 2010 (2010-01-14) claims, examples | 1-62 |
| X | JP 2009-197165 A (SEKISUI CHEMICAL CO., LTD.) 03 September 2009 (2009-09-03) claims, examples | 1-62 |
| X | JP 2010-185991 A (JSR CORPORATION) 26 August 2010 (2010-08-26) claims, examples | 1-62 |
| X | WO 2020/203472 A1 (DAI NIPPON PRINTING CO., LTD.) 08 October 2020 (2020-10-08) claims, examples | 1-62 |
| X | JP 2013-155258 A (ASAHI KASEI E-MATERIALS CORP.) 15 August 2013 (2013-08-15) claims, examples | 1-62 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 November 2024** | **19 November 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No.
**PCT/JP2024/032123**

**C. DOCUMENTS CONSIDERED TO BE RELEVANT**

| Category* | Citation of document, with indication, where appropriate, of the relevant passages | Relevant to claim No. |
|---|---|---|
| X | JP 2013-163785 A (ASAHI KASEI E-MATERIALS CORP.) 22 August 2013 (2013-08-22) claims, examples | 1-62 |
| X | JP 2013-163786 A (ASAHI KASEI E-MATERIALS CORP.) 22 August 2013 (2013-08-22) claims, examples | 1-62 |
| X | JP 2013-163789 A (ASAHI KASEI E-MATERIALS CORP.) 22 August 2013 (2013-08-22) claims, examples | 1-62 |
| X | JP 2013-163354 A (ASAHI KASEI E-MATERIALS CORP.) 22 August 2013 (2013-08-22) claims, examples | 1-62 |

Form PCT/ISA/210 (second sheet) (July 2022)

**INTERNATIONAL SEARCH REPORT**

International application No.
**PCT/JP2024/032123**

**Box No. III Observations where unity of invention is lacking (Continuation of item 3 of first sheet)**

This International Searching Authority found multiple inventions in this international application, as follows:

(Invention 1) Claims 1-24, 27-34, and 40-47, claims 35-38 referring to any one of claims 27-34, and claims 48-62 referring to claim 40

Claims 1-24, 27-34, and 40-47, claims 35-38 referring to any one of claims 27-34, and claims 48-62 referring to claim 40 have the special technical feature in which organopolysiloxane is "represented by general formula 1," and are thus classified as invention 1.

(Invention 2) Claims 25-26, and claims 35-38 referring to claim 25 or 26

Claims 25-26, and claims 35-38 referring to claim 25 or 26 share, with claims 1-24, 27-34, and 40-47 classified as invention 1, claims 35-38 referring to any one of claims 27-34, and claims 48-62 referring to claim 40, the common technical feature of "comprising a siloxane unit (D unit) represented by $SiO_{2/2}$."

However, the technical feature is well known that it is not necessary to provide documents, does not make a contribution over the prior art, and thus cannot be said to be a special technical feature. Also, there are no other same or corresponding special technical features between these inventions.

Additionally, claims 25-26, and claims 35-38 referring to claim 25 or 26 do not depend from claim 1. Furthermore, claims 25-26, and claims 35-38 referring to claim 25 or 26 are not substantially identical to or similarly closely related to any of the claims classified as invention 1.

Therefore, claims 25-26, and claims 35-38 referring to claim 25 or 26 cannot be classified as invention 1.

Moreover, claims 25-26, and claims 35-38 referring to claim 25 or 26 have the specific technical feature of a "cured product comprising: a crosslinked structure derived from an organic group containing a polymerizable alkenyl group; and a siloxane unit (D unit) represented by $SiO_{2/2}$, wherein a refractive index at a wavelength of 1300 nm is 1. 400 or more and 1. 500 or less," and are thus classified as invention 2.

(Invention 3) Claim 39, and claims 48-62 referring to claim 39

Claim 39, and claims 48-62 referring to claim 39 share, with claims 1-24, 27-34, and 40-47 classified as invention 1, claims 35-38 referring to any one of claims 27-34, and claims 48-62 referring to claim 40, the common technical feature in which organopolysiloxane "includes an organic group containing a polymerizable alkenyl group, and a siloxane unit (D unit) represented by $SiO_{2/2}$, and a proportion of an aromatic group with respect to the total of all groups bonded to silicon atoms is 20 mol% or less."

Also, claim 39, and claims 48-62 referring to claim 39 share, with claims 25-26 classified as invention 2, and claims 35-38 referring to claim 25 or 26, the common technical feature of "containing a siloxane unit (D unit) represented by $SiO_{2/2}$."

However, the technical feature is so well known that it is not necessary to provide documents, does not make a contribution over the prior art, and thus cannot be said to be a special technical feature. Also, there are no other same or corresponding special technical features between these inventions.

Additionally, claims 39, and claims 48-62 referring to claim 39 do not depend from claim 1 or 25. Furthermore, claim 39, and claims 48-62 referring to claim 39 are not substantially identical to or similarly closely related to any of the claims classified as invention 1 or 2.

Therefore, claim 39, and claims 48-62 referring to claim 39 cannot be classified as either invention 1 or invention 2.

Moreover, claim 39, and claims 48-62 referring to claim 39 have the special technical feature in which organopolysiloxane for near-infrared optical waveguides "includes an organic group containing a polymerizable alkenyl group and a siloxane unit (D unit) represented by $SiO_{2/2}$, and a proportion of an aromatic group with respect to the total of all groups bonded to silicon atoms is 20 mol% or less," and are thus classified as invention 3.

INTERNATIONAL SEARCH REPORT

International application No.
PCT/JP2024/032123

**Box No. III Observations where unity of invention is lacking (Continuation of item 3 of first sheet)**

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet) (July 2022)

**INTERNATIONAL SEARCH REPORT**
**Information on patent family members**

International application No.
**PCT/JP2024/032123**

| Patent document cited in search report | Publication date (day/month/year) | Patent family member(s) | Publication date (day/month/year) |
|---|---|---|---|
| WO 2015/037571 A1 | 19 March 2015 | US 2016/0200842 A1<br>claims, examples<br>KR 10-2016-0055155 A | |
| JP 2010-006939 A | 14 January 2010 | (Family: none) | |
| JP 2009-197165 A | 03 September 2009 | (Family: none) | |
| JP 2010-185991 A | 26 August 2010 | (Family: none) | |
| WO 2020/203472 A1 | 08 October 2020 | US 2022/0169774 A1<br>claims, examples<br>CN 113614132 A<br>KR 10-2021-0148133 A | |
| JP 2013-155258 A | 15 August 2013 | (Family: none) | |
| JP 2013-163785 A | 22 August 2013 | (Family: none) | |
| JP 2013-163786 A | 22 August 2013 | (Family: none) | |
| JP 2013-163789 A | 22 August 2013 | (Family: none) | |
| JP 2013-163354 A | 22 August 2013 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005163009 A
- JP 2014510159 T